(19) Europäisches Patentamt
European Patent Office
Office européen des brevets

(11) **EP 1 860 838 B1**

(12) **EUROPÄISCHE PATENTSCHRIFT**

(45) Veröffentlichungstag und Bekanntmachung des Hinweises auf die Patenterteilung:
**14.08.2013 Patentblatt 2013/33**

(21) Anmeldenummer: **06010756.2**

(22) Anmeldetag: **24.05.2006**

(51) Int Cl.:
*H04L 25/02* (2006.01)  *H04L 27/18* (2006.01)

(54) **Datenübertragung durch Phasenmodulation über zwei Signalpfaden**

Data transmission using phase modulation over two signal paths

Transmission de données à modulation de phase sur deux chemins de signaux

(84) Benannte Vertragsstaaten:
**DE FR GB IT**

(43) Veröffentlichungstag der Anmeldung:
**28.11.2007 Patentblatt 2007/48**

(73) Patentinhaber: **Infineon Technologies AG**
**85579 Neubiberg (DE)**

(72) Erfinder: **Feldtkeller, Martin**
**81543 München (DE)**

(74) Vertreter: **Bickel, Michael**
**Westphal, Mussgnug & Partner**
**Patentanwälte**
**Herzog-Wilhelm-Strasse 26**
**80331 München (DE)**

(56) Entgegenhaltungen:
**DE-A1- 10 232 642    DE-B- 1 052 447**
**US-A- 5 235 617    US-A1- 2002 017 919**

**Beschreibung**

Die vorliegende Erfindung betrifft eine Signalübertragungsvorrichtung mit zwei Übertragern, die jeweils eine Primärwicklung und eine Sekundärwicklung aufweisen, sowie ein Signalübertragungsverfahren über eine solche Übertragungsvorrichtung.

Eine Signalübertragungsvorrichtung mit zwei jeweils eine Primärwicklung und eine Sekundärwicklung aufweisenden Übertragern und ein Übertragungsverfahren für einen solchen Übertrager ist in der US 6,525,566 B2 beschrieben. Zur Übertragung eines zweiwertigen Nutzsignals ist bei diesem bekannten Verfahren vorgesehen, ein Oszillatorsignal zur Verfügung zu stellen, das der Primärwicklung eines ersten der beiden Übertrager direkt zugeführt ist und das der Primärwicklung eines zweiten der beiden Übertrager moduliert durch das Nutzsignal zugeführt ist. Die Modulation erfolgt dabei derart, dass das dem zweiten Übertrager zugeführte Oszillatorsignal abhängig von dem momentanen Signalpegel des Nutzsignals ein zu dem Oszillatorsignal des ersten Übertragers gleichphasiges oder gegenphasiges Signal ist.

Bei dieser Übertragungsvorrichtung ist ein Taktgenerator zur Erzeugung eines Oszillatorsignals erforderlich, der bei hoher Frequenz des Oszillatorsignals zu einer nicht unerheblichen Erwärmung der Übertragungsvorrichtung beiträgt.

Aufgabe der vorliegenden Erfindung ist es, eine Signalübertragungsvorrichtung mit zwei Übertragern zur Verfügung zu stellen, die einfach realisierbar ist und die die oben bezeichneten Nachteile nicht aufweist, und ein Signalübertragungsverfahren über eine solche Übertragungsvorrichtung zur Verfügung zu stellen.

Die DE 1 052 447 beschreibt eine Schaltungsanordnung zur Verstärkung von Gleichstrom-Telegraphiezeichen bei gleichzeitiger galvanischer Entkopplung der Gleichstrom-Telegraphiekreise. Bei dieser Anordnung ist ein von ankommenden Telegraphiezeichen gesteuerter Modulator vorhanden, der eine Hilfsschwingung entsprechend einer Polarität von Telegraphieschritten phasenmoduliert, wobei die phasenmodulierte Hilfsschwingung einem Verstärker zugeführt ist. Die Anordnung weist außerdem einen Demodulator auf, der die verstärkte phasenmodulierte Hilfsschwingung wieder demoduliert.

Diese Aufgabe wird durch eine Signalübertragungsvorrichtung nach Anspruch 1 und durch ein Signalübertragungsverfahren nach Anspruch 23 gelöst. Vorteilhafte Ausgestaltungen der Erfindung sind Gegenstand der Unteransprüche.

Die Signalübertragungsvorrichtung umfasst einen ersten Übertrager mit einer Primärwicklung und einer Sekundärwicklung und einen zweiten Übertrager mit einer Primärwicklung und einer Sekundärwicklung, einen ersten Schwingkreis, der eine Wicklung des ersten Übertragers enthält, und einen zweiten Schwingkreis, der eine Wicklung des zweiten Übertragers enthält. Zwischen dem ersten Schwingkreis und dem zweiten Schwingkreis ist ein Kopplungselement angeordnet. Außerdem ist eine erste Anregungsschaltung an den ersten Schwingkreis angeschlossen und wenigstens eine weitere Anregungsschaltung an den zweiten Schwingkreises angeschlossen.

Das Signalübertragungsverfahren für die Übertragung von wenigstens zwei unterschiedlichen Sendesymbolen sieht vor eine Übertragungsvorrichtung mit einem ersten Übertrager, der eine Primärwicklung und eine Sekundärwicklung aufweist und dessen Primärwicklung oder Sekundärwicklung Teil eines ersten Schwingkreises ist, und mit einem zweiten Übertrager, der eine Primärwicklung und eine Sekundärwicklung aufweist und dessen Primärwicklung Sekundärwicklung Teil eines zweiten Schwingkreises ist, bereitzustellen. Für die Übertragung jedes der wenigstens zwei unterschiedlichen Sendesymbole werden der erste Schwingkreis und der zweite Schwingkreises zu phasenverschobenen Schwingungen mit einer Phasenverschiebung ungleich Null angeregt. Zur Rückgewinnung der übertragenen Information wird eine Phasenbeziehung von an den Sekundärwicklungen der Übertrager abgreifbaren Signalen ausgewertet.

Die vorliegende Erfindung wird nachfolgend anhand von Figuren näher erläutert.

Figur 1    zeigt ein Ausführungsbeispiel eines erfindungsgemäßen Signalübertragers, der zwei Übertrager mit je einer Primärwicklung und einer Sekundärwicklung und der zwei Schwingkreise aufweist und bei dem die Schwingkreise primärseitig realisiert sind und durch Anregungsschaltungen anregbar sind.

Figur 2    zeigt - ohne Berücksichtigung von Einschwingvorgängen - Spannungen an den Primärwicklungen der Übertrager bei Anregung der Schwingkreise durch die Anregungsschaltungen.

Figur 3    veranschaulicht die Phasenbeziehungen von Schwingungen der Schwingkreise des Signalübertragers für verschiedene Betriebszustände anhand von komplexen Zeigerdiagrammen.

Figur 4    zeigt ein Ausführungsbeispiel eines Signalübertragers, bei dem die Schwingkreise sekundärseitig realisiert sind.

Figur 5    zeigt ein Ausführungsbeispiel eines Signalübertragers, bei dem die Schwingkreise primärseitig realisiert sind und bei dem die Anregungsschaltungen induktiv an die Schwingkreise gekoppelt sind.

Figur 6      zeigt ein Ausführungsbeispiel einer an die Sekundärwicklungen der Übertrager gekoppelten Empfangsschaltung.

Figur 7      zeigt ein weiteres Ausführungsbeispiel einer sekundärseitigen Empfangsschaltung.

Figur 8      zeigt ein Realisierungsbeispiel der Anregungsschaltungen.

Figur 9      zeigt ein weiteres Ausführungsbeispiel der sekundärseitigen Empfangsschaltung.

Figur 10      zeigt ein Ausführungsbeispiel eines passiven Netzwerks zur Realisierung der Empfangsschaltung nach Figur 7.

Figur 11      zeigt ein weiteres Ausführungsbeispiel einer sekundärseitigen Empfangsschaltung.

Figur 12      veranschaulicht ein mögliches Verfahren zur Übertragung eines zweiwertigen Datensignals über die erfindungsgemäße Signalübertragungsvorrichtung.

Figur 13      veranschaulicht ein grundsätzliches Kodierungsschema für das in Figur 12 erläuterte Verfahren.

Figur 14      veranschaulicht ein Verfahren zur seriellen Übertragung von drei jeweils zweiwertigen Datensignalen und die bei diesem Verfahren primärseitig an dem Signalübertrager auftretenden Signale.

Figur 15      veranschaulicht ein grundsätzliches Kodierschema für das in Figur 14 erläuterte Verfahren.

Figur 16      veranschaulicht die bei dem Verfahren nach Figur 14 sekundärseitig an Signalübertrager auftretenden Signale.

Figur 17      zeigt ein weiteres Ausführungsbeispiel eines erfindungsgemäßen Signalübertragers.

In den Figuren bezeichnen, sofern nicht anders angegeben, gleiche Bezugszeichen gleiche Schaltungskomponenten und Signale mit gleicher Bedeutung.

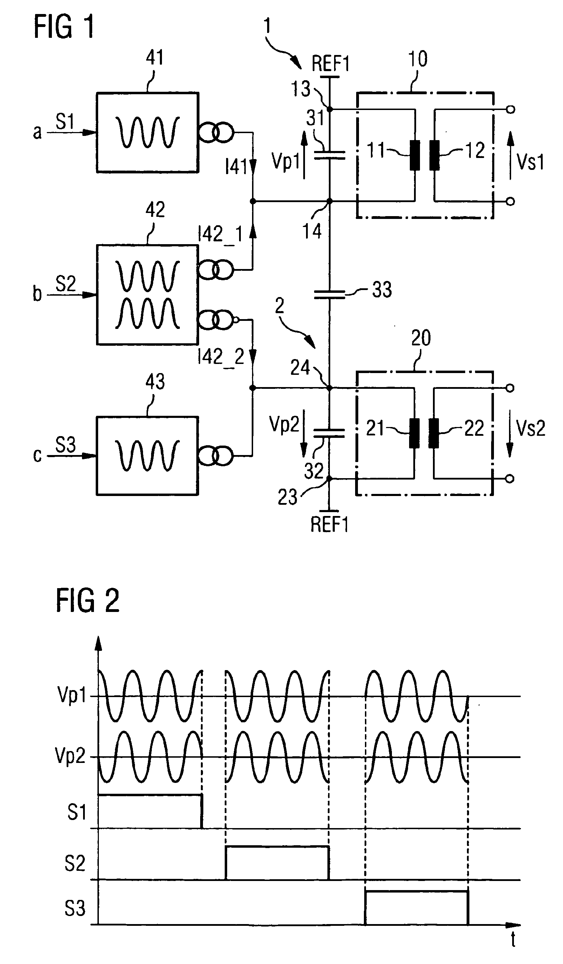

Ein Ausführungsbeispiel eines erfindungsgemäßen Signalübertragers ist in Figur 1 dargestellt. Dieser Signalübertrager umfasst zwei Übertrager 10, 20, die jeweils eine Primärwicklung 11, 21 und eine induktiv mit der Primärwicklung 11, 21 gekoppelte Sekundärwicklung 12, 22 aufweisen. Diese Übertrager sind beispielsweise als "Coreless Transformer" realisiert, weisen also keinen die induktive Kopplung zwischen den Primärwicklungen 11, 21 und den Sekundärwicklungen 12, 22 verstärkenden Transformatorkern auf. Solche Coreless Transformer sind hinlänglich bekannt und beispielsweise in DE 101 00 282 A1 oder DE 102 32 642 A1 beschrieben.

Die Signalübertragungsvorrichtung weist außerdem zwei Schwingkreise 1, 2 mit je einer Schwingkreisinduktivität und einer Schwingkreiskapazität 31, 32 auf. Diese Schwingkreise sind in dem dargestellten Beispiel primärseitig, d.h. auf der Seite der Primärwicklungen 11, 21, angeordnet und weisen die Primärwicklungen 11, 21 als Schwingkreisinduktivitäten auf. Diese Schwingkreise 1, 2 sind in dem Beispiel als Parallelschwingkreise ausgebildet, und dadurch realisiert, dass parallel zu der Primärwicklung 11 des ersten Übertragers 10 ein erstes kapazitives Speicherelement 31 als erste Schwingkreiskapazität und parallel zu der Primärwicklung 21 des zweiten Übertragers 20 ein zweites kapazitives Speicherelement 32 als zweite Schwingkreiskapazität geschaltet ist. Diese kapazitiven Speicherelemente 31, 32 sind beispielsweise Kondensatoren.

Ein erster Anschluss 13 des ersten Schwingkreises 1 ist durch einen ersten der Primärwicklung 11 und dem kapazitiven Speicherelement 31 gemeinsamen Schaltungsknoten gebildet, und ein zweiter Anschluss 14 dieses ersten Schwingkreises 1 ist durch einen zweiten der Primärwicklung 11 und dem kapazitiven Speicherelement 31 gemeinsamen Schaltungsknoten gebildet. Entsprechend ist ein erster Anschluss 23 des zweiten Schwingkreises 2 durch einen ersten der Primärwicklung 21 und dem zweiten kapazitiven Speicherelement 32 gemeinsamen Schaltungsknoten gebildet. Ein zweiter Anschluss 24 dieses zweiten Schwingkreises 2 ist durch einen zweiten der Primärwicklung 21 und dem kapazitiven Speicherelement 32 gemeinsamen Schaltungsknoten gebildet. Die ersten Anschlüsse 13, 23 der Schwingkreise sind in dem Beispiel jeweils an eine Klemme für ein primärseitiges Bezugspotential REF1 angeschlossen. Dieses Bezugspotential kann ein beliebiges Potential, insbesondere auch ein Versorgungspotential sein.

Die beiden Schwingkreise 1, 2 sind bei der dargestellten Signalübertragungsvorrichtung derart miteinander gekoppelt, dass bei Anregung eines Schwingkreises zu einer Schwingung gleichzeitig eine Anregung des anderen Schwingkreises zu einer Schwingung erfolgt. Zur Kopplung der beiden Schwingkreise 1, 2 ist ein Kopplungselement 33 vorhanden, das zwischen die zweiten Anschlüsse 14, 24 der beiden Schwingkreise 1, 2 geschaltet ist. Dieses Kopplungselement 33 ist in dem Beispiel als kapazitives Kopplungselement in Form eines kapazitiven Speicherelementes, insbesondere eines Kondensators, realisiert. Es könnte jedoch auch ein beliebiges anderes Kopplungselement vorgesehen werden, das dazu geeignet ist, bei Anregung eines der beiden Schwingkreise zu einer Schwingung eine Anregung des jeweils anderen Schwingkreises zu einer phasenverschobenen Schwingung bewirken. Als Kopplungselement könnte insbesondere auch ein induktives Kopplungselement vorgesehen werden.

Die beiden Schwingkreise gemäß Figur 1 sind unmittelbar miteinander gekoppelt, indem das Kopplungselement 33 zwischen die Schwingkreisinduktivitäten 11, 21 der beiden Schwingkreise 1, 2 geschaltet ist. Alternativ besteht die Möglichkeit, die beiden Schwingkreise indirekt über die Sekundärwicklungen 12, 22 der Übertrager 10, 20 zu koppeln. Das Kopplungselement wird hierbei in nicht näher dargestellter Weise zwischen die Sekundärwicklungen geschaltet.

Die dargestellte Signalübertragungsschaltung umfasst zur Anregung der beiden Schwingkreise 1, 2 drei Anregungsschaltungen 41, 42, 43, die jeweils abhängig von einem Steuersignal S1, S2, S3 die Schwingkreise zu Schwingungen anregen. Für die weitere Erläuterung wird davon ausgegangen, dass diese Steuersignale S1, S2, S3 jeweils zweiwertige Signale sind, die einen ersten oder einen zweiten Signalpegel annehmen können. Des weiteren wird angenommen, dass die Anregungsschaltungen 41, 42, 43 bei einem ersten Pegel des ihnen jeweils zugeführten Steuersignals S1, S2, S3 aktiviert sind, um die Schwingkreise anzuregen und dass die Anregungsschaltungen bei einem zweiten Pegel des ihnen jeweils zugeführten Steuersignals deaktiviert sind.

Einer ersten 41 der Anregungsschaltungen ist an einem Steuereingang ein erstes S1 der Steuersignale zugeführt. Diese erste Anregungsschaltung 41 ist dazu ausgebildet, den ersten Schwingkreis 11, 31 abhängig von diesem Steuersignal S1 zu einer Schwingung anzuregen. In aktiviertem Zustand liefert diese erste Anregungsschaltung 41 einen Anregungsstrom I41 mit periodisch wechselnder Stromrichtung oder zumindest periodisch variierender Stromstärke an den ersten Schwingkreis 1. Die Frequenz, mit der sich die Stromrichtung bzw. die Stromstärke ändert ist dabei von der Resonanzfrequenz des Schwingkreises 1 abhängig. Der Anregungsstrom kann hierbei einen rechteckförmigen Stromverlauf besitzen.

Der Ausgang der ersten Anregungsschaltung 41 ist in dem dargestellten Beispiel zur Anregung des ersten Schwingkreises 1 an den zweiten Anschluss 14 dieses ersten Schwingkreises 1 angeschlossen.

Über das Kopplungselement 33 ist der Ausgang der ersten Anregungsschaltung 41 auch an den zweiten Anschluss 24 des zweiten Schwingkreises 2 angeschlossen, wodurch gleichzeitig mit Anregung des ersten Schwingkreises 1 auch eine Anregung des zweiten Schwingkreises 2 erfolgt.

Einer zweiten 42 der Anregungsschaltungen ist an einem Steuereingang ein zweites S2 der Steuersignale zugeführt. Diese zweite Anregungsschaltung 42 ist dazu ausgebildet, nach Maßgabe des zweiten Steuersignals S2 den ersten Schwingkreis zu einer Schwingung anzuregen und gleichzeitig den zweiten Schwingkreis zu einer Schwingung anzuregen, die phasenverschoben zu der Schwingung des ersten Schwingkreises ist. Die zweite Anregungsschaltung 42 umfasst hierfür zwei Ausgänge, von denen ein erster Ausgang an den zweiten Anschluss 14 des ersten Schwingkreises 1 angeschlossen ist, und von denen ein zweiter Ausgang, an den zweiten Anschluss 24 des zweiten Schwingkreises 2 angeschlossen ist.

Die zweite Anregungsschaltung 42 liefert in aktiviertem Zustand einen ersten Anregungsstrom I42_1 mit einer periodisch wechselnden Stromrichtung oder zumindest einer periodisch variierenden Stromstärke an den ersten Schwingkreis 1 und einen zweiten Anregungsstrom I42_2 mit einer periodisch wechselnden Stromrichtung oder zumindest einer periodisch variierenden Stromstärke an den zweiten Schwingkreis 2. Die Frequenzen, mit der sich die Stromrichtungen der Anregungsströme I42_1, I42_2 bzw. die Stromstärken ändern, sind dabei von den Resonanzfrequenzen der ersten und zweiten Schwingkreise abhängig. Vorzugsweise sind diese Schwingkreise so dimensioniert, dass diese Resonanzfrequenzen wenigstens annäherungsweise gleich sind.

Die Signalverläufe des ersten und zweiten Anregungsstromes I41_1, I42_2 sind gegeneinander phasenverschoben. Die Phasenverschiebung zwischen diesen Anregungsströmen I41_1, I42_2 bestimmt dabei die Phasenverschiebung zwischen den Schwingungen des ersten und zweiten Schwingkreises 1, 2.

Einer dritten der Anregungsschaltungen 43 ist an einem Steuereingang ein drittes Steuersignal S3 zugeführt. Diese dritte Anregungsschaltung 43 ist dazu ausgebildet, nach Maßgabe dieses dritten Steuersignals S3 den zweiten Schwingkreis zu einer Schwingung anzuregen. In aktiviertem Zustand liefert diese dritte Anregungsschaltung 43 einen Anregungsstrom I43 mit periodisch wechselnder Stromrichtung oder zumindest einer periodisch variierenden Stromstärke an den zweiten Schwingkreis 2. Die Frequenz, mit der sich die Stromrichtung bzw. die Stromstärke ändert ist dabei von der Resonanzfrequenz des zweiten Schwingkreises 2 abhängig.

Der Ausgang der dritten Anregungsschaltung 43 ist in dem dargestellten Beispiel zur Anregung des zweiten Schwingkreises 2 an den zweiten Anschluss 24 dieses zweiten Schwingkreises 2 angeschlossen.

Über das Kopplungselement 33 ist der Ausgang der dritten Anregungsschaltung 43 auch an den zweiten Anschluss 14 des ersten Schwingkreises 1 angeschlossen, wodurch gleichzeitig mit Anregung des zweiten Schwingkreises 2 auch eine Anregung des ersten Schwingkreises 1 erfolgt.

Die Resonanzfrequenzen der beiden Schwingkreise 1, 2 sind von den Bauelementeigenschaften der Primärwicklungen 11, 21 und der kapazitiven Speicherelemente 31, 32 abhängig. Diese Bauelemente sind vorzugsweise so gewählt, dass die Resonanzfrequenzen der beiden Schwingkreise wenigstens annäherungsweise gleich sind. Diese Resonanzfrequenz kann so gewählt werden, dass sie bis zu einigen hundert MHz beträgt.

Für die bisherige Erläuterung wurde davon ausgegangen, dass die den Schwingkreisen 1, 2 von den Anregungsschaltungen 41, 42, 43 zugeführten Anregungsströme periodisch ihre Stromrichtung ändern. Ein gleicher Effekt im Hinblick auf die Anregung der Schwingkreise 1, 2 kann in nicht näher dargestellter Weise auch dadurch erreicht werden, dass die Anregungsschaltungen nur in einer Richtung fließende Ströme an deren Ausgängen bereitstellen, dass die Stromstärke jedoch periodisch zwischen einem hohen und einem niedrigen Wert wechselt.

Zur Signalübertragung wird die erläuterte Signalübertragungsvorrichtung derart betrieben, dass zu einem Zeitpunkt nur jeweils eine der Anregungsschaltungen 41, 42, 43 angesteuert durch das jeweilige Steuersignal S1, S2, S3 aktiviert ist.

Mit dem in Figur 1 dargestellten Signalübertrager lassen sich abhängig davon, welche der drei Anregungsschaltungen 41, 42, 43 aktiviert ist, drei voneinander unterscheidbare Nutzinformationen übertragen. Diese Nutzinformationen werden nachfolgend als Sendesymbole a, b, c bezeichnet. Je eines dieser Sendesymbole ist dabei in der in Figur dargestellten Weise einem der Steuersignale S1, S2, S3 zugeordnet. Die Übertragung eines dieser Sendesymbole, beispielsweise des Sendesymbols a, erfolgt dann, wenn das zugeordnete Steuersignal, beispielsweise das erste Steuersignal S1, einen Pegel aufweist, bei dem die Anregungsschaltung, der das Steuersignal zugeführt ist, aktiviert ist.

Die zu übertragende Information ist bei dem erläuterten Signalübertrager in der Phasenbeziehung zwischen einem Schwingungssignal des ersten Schwingkreises 1 und einem Schwingungssignal des zweiten Schwingkreises 2 enthalten. Das Schwingungssignal ist hierbei sowohl eine Spannung über den Schwingkreisen 1, 2 als auch ein in den Schwingkreisen 1, 2 fließender Strom.

Für die nachfolgende Erläuterung werden die Spannungen über den Schwingkreisen 1, 2 betrachtet, die bei den dargestellten Parallelschwingkreisen den Spannungen über den Primärwicklungen 11, 21 entsprechen. Werden bei dem Signalübertrager die primärseitigen Schwingkreise 1 bzw. 2 zu Schwingungen angeregt, ergibt sich ein sinusförmiger Signalverlauf der Spannungen Vp1, Vp2 über den Primärwicklungen 11, 21. Diese Primärspannungen Vp1, Vp2 induzieren in den Sekundärwicklungen 12, 22 der Übertrager 10, 20 Sekundärspannungen Vs1, Vs2. Diese Sekundärspannungen Vs1, Vs2 besitzen einen dem Verlauf der Primärspannung Vp1, Vp2 entsprechenden sinusförmigen Verlauf, wobei der Signalverlauf einer Sekundärspannung Vs1, Vs2 gegenüber dem Signalverlauf der zugehörigen Primärspannung Vp1, Vp2 phasenverschoben sein kann. Die Phasenbeziehung zwischen den Primärspannungen Vp1, Vp2 wird jedoch auf die Sekundärspannungen Vs1, Vs2 übertragen. Bei einer gegebenen Phasenverschiebung zwischen der ersten Primärspannung Vp1 und der zweiten Primärspannung Vp2 sind also die erste Sekundärspannung Vs1 und die zweite Sekundärspannung Vs2 um die gleiche Phasenverschiebung gegeneinander phasenverschoben.

Zur Übertragung von drei unterschiedlichen Informationssymbolen ist es erforderlich, die beiden Schwingkreise derart anzuregen, dass sich drei eindeutig voneinander unterscheidbare Phasenbeziehungen zwischen der Schwingung des ersten Schwingkreises 1 und der Schwingung des zweiten Schwingkreises 2 ergeben. Phasenverschiebungen zwischen der Schwingung des ersten und zweiten Schwingkreises 1, 2 betragen hierfür beispielsweise 90°, 180° oder 270°.

Zur Ermittlung der Phasenverschiebungen bzw. Phasendifferenzen wird für die nachfolgende Erläuterung die Phase der Schwingung des zweiten Schwingkreises 2 bezogen auf die Phase der Schwingung des ersten Schwingkreise betrachtet. Eine positive Phasendifferenz liegt dann vor, wenn die Phase der zweiten Schwingung der Phase der ersten Schwingung vorauseilt.

Wird bei der dargestellten Signalübertragungsvorrichtung der erste Schwingkreis 1 durch die erste Anregungsschaltung 41 zu einer Schwingung angeregt, so wird bedingt durch die kapazitive Kopplung des Ausgangs der ersten Anregungsschaltung 41 an den zweiten Schwingkreis 2 auch der zweite Schwingkreis 2 zu einer Schwingung angeregt. Die kapazitive Kopplung bewirkt dabei eine Phasenverschiebung von +90° bzw. -270° zwischen diesen beiden Schwingungen, so dass die Schwingung des zweiten Schwingkreises 21, 32 der des ersten Schwingkreises 11, 31 um 90° vorauseilt bzw. um 270° nacheilt. Dies ist in Figur 2 veranschaulicht, in der für eine Anregung der ersten Anregungsschaltung 41 die Schwingungsverläufe der ersten und zweiten Schwingung dargestellt sind. Die Aktivierung der ersten Anregungsschaltung 41 ist in Figur 2 durch einen High-Pegel des ersten Steuersignals S1 dargestellt.

Aus Gründen der Übersichtlichkeit sind bei den zeitlichen Verläufen in Figur 2 Einschwingvorgänge, während derer die Amplitude der jeweiligen Spannung Vp1, Vp2 erst ansteigt, nicht berücksichtigt.

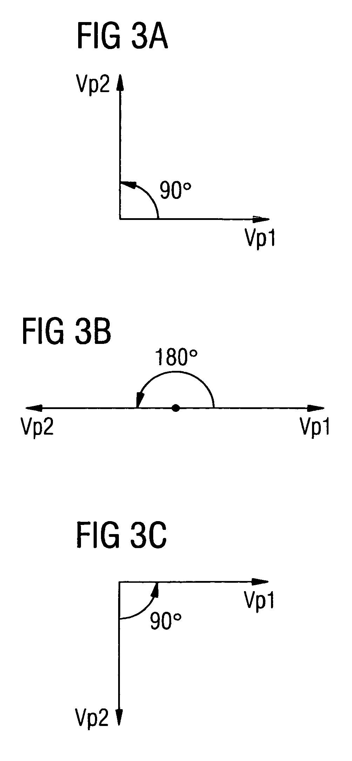

Die Phasenbeziehung zwischen den schwingungsförmigen ersten und zweiten Primärspannungen Vp1, Vp2 für den Fall einer Aktivierung der ersten Anregungsschaltung 41 ist außerdem in Figur 3A in Form eines komplexen Zeigerdiagramms dargestellt. Vp1, Vp2 bezeichnen in Figur 3A komplexe Zeiger der Primärspannungen. Der komplexe Zeiger der zweiten Primärspannung Vp2 eilt dabei dem komplexen Zeiger der ersten Primärspannung Vp1 um 90° voraus.

Bei einer Anregung der zweiten Anregungsschaltung 42 angesteuert durch das zweite Steuersignal S2 werden die beiden Schwingkreise zu Schwingungen angeregt, deren Phasenbeziehung durch die Phasenbeziehung der Anregungssignale I42_1, I42_2 vorgegeben ist. Diese Anregungsströme sind beispielsweise gegenphasig zueinander, d.h. um 180° gegeneinander phasenverschoben. Die ersten und zweiten Primärspannungen Vp1, Vp2 sind dadurch um 180° gegeneinander phasenverschoben, wie in Figur 2 für einen High-Pegel des zweiten Steuersignals S2 und in Figur 3B im komplexen Zeigerdiagramm dargestellt ist.

Bei einer Anregung des zweiten Schwingkreises 21, 32 durch die dritte Anregungsschaltung 43 gesteuert durch das dritte Steuersignal S3 wird bedingt durch die kapazitive Kopplung der beiden Schwingkreise auch der erste Schwingkreis 11, 31 angeregt. Der Signalverlauf der ersten Primärspannung Vp1 eilt in diesem Fall dem Signalverlauf der zweiten Primärspannung Vp2 um 90° voraus bzw. um 270° hinterher. Dies ist gleichbedeutend damit, dass die Phase der Schwingung des zweiten Schwingkreises 2 der Phase der Schwingung des ersten Schwingkreises 1 um 90° nacheilt bzw. um 270° vorauseilt. Die Phasenverschiebung beträgt damit -90° bzw. +270°.

Alternativ oder zusätzlich zu der zweiten Anregungsschaltung kann auch eine vierte Anregungsschaltung vorhanden sein, die beide Schwingkreise gleichphasig anregt. Gleichphasige Anregungen könnten jedoch auch durch elektromagnetische Einstreuungen in die Übertrager entstehen, die dann von einer echten gleichphasigen Anregung sekundärseitig nicht unterscheidbar wären. Auf die gleichphasige Anregung zur Signalübertragung wird daher verzichtet.

Mit der dargestellten Signalübertragungsvorrichtung lassen sich somit drei unterschiedliche Phasenbeziehungen zwischen den Primärspannungen Vp1, Vp2 und damit auch zwischen den Sekundärspannungen Vs1, Vs2 der Übertrager einstellen. Abhängig davon, welche Anregungsschaltung 41, 42, 43 aktiviert ist, d. h. welches der Sendesymbole a, b, c übertragen werden soll, beträgt die Phasenverschiebung zwischen den Primärspannungen Vp1, Vp2 +90° (=-270°), -90° (=+270°) oder 180° und entsprechend auch zwischen den Sekundärspannungen +90°, -90° oder 180°.

Mit Vp1($\omega$t) ist nachfolgend die sich über der Zeit periodisch ändernde Primärspannung des angeregten ersten Schwingkreises 1 bezeichnet. $\omega$ bezeichnet dabei die Resonanzfrequenz des Schwingkreises 1, und t bezeichnet die Zeit. Entsprechend ist mit Vp2($\omega$t) nachfolgend die sich über der Zeit periodisch ändernde Primärspannung des angeregten zweiten Schwingkreises 2 bezeichnet.

Die oben erläuterten Phasenbeziehungen lassen sich unter Verwendung von Vp1($\omega$t) und Vp2($\omega$t) wie folgt darstellen:

Bei Übertragung des ersten Sendesymbols a d. h. bei Aktivierung der ersten Anregungsschaltung 41 gilt:

$$\text{Vp1}(\omega t) = \text{Vp2}(\omega t - 90°) \tag{1a}$$

$$\text{Vs1}(\omega t) = \text{Vs2}(\omega t - 90°) \tag{1b}.$$

Die zweite Primärspannung Vp2 bzw. die zweite Sekundärspannung Vs2 eilen somit der ersten Primärspannung Vp1 bzw. der ersten Sekundärspannung Vs1 um 90° voraus, die Phasenverschiebung beträgt also +90°.

Bei Übertragung des zweiten Sendesymbols b gilt:

$$\text{Vp1}(wt) = \text{Vp2}(wt \pm 180°) \tag{2a}$$

$$\text{Vs1}(wt) = \text{Vs2}(wt \pm 180°) \tag{2b}.$$

Die Primärspannungen Vp1, Vp2 und die Sekundärspannungen Vs1, Vs2 sind also jeweils um 180° gegeneinander phasenverschoben.

Für die Übertragung des dritten Sendesymbols gilt:

$$\text{Vp1}(\omega t) = \text{Vp2}(\omega t + 90°) \tag{3a}$$

$$\text{Vs1}(\omega t) = \text{Vs2}(\omega t + 90°) \tag{3b}.$$

Die zweite Primärspannung Vp2 bzw. die zweite Sekundärspannung Vs2 eilen somit der ersten Primärspannung Vp1 bzw. der ersten Sekundärspannung Vs1 um 90° hinterher, die Phasenverschiebung beträgt also -90°.

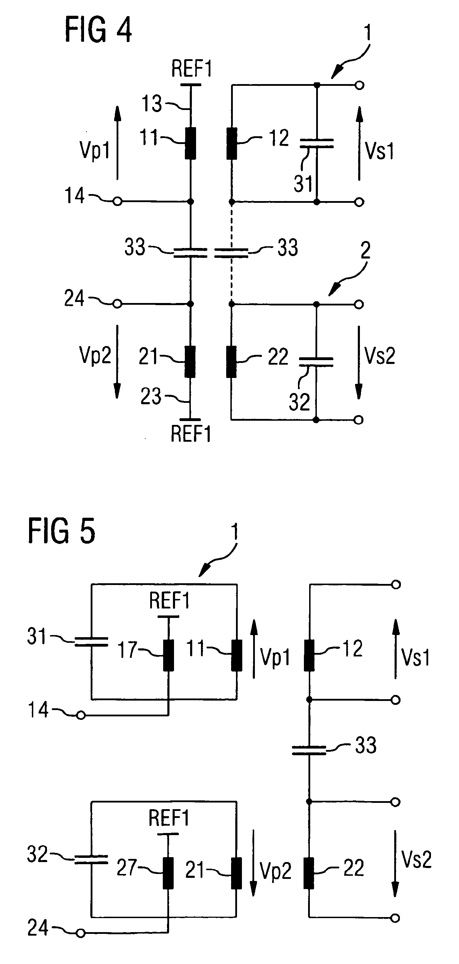

Alternativ zu dem in Figur 1 dargestellten Ausführungsbeispiel, bei dem die Schwingkreise primärseitig angeordnet sind, besteht bezugnehmend auf Figur 4 die Möglichkeit, die Schwingkreise sekundärseitig zu realisieren. Die Schwingkreise gemäß Figur 4 sind als Parallelschwingkreise realisiert, deren Schwingkreisinduktivitäten durch die Sekundärwicklungen 12, 22 gebildet sind. Parallel zu den Sekundärwicklungen sind hierbei jeweils Schwingkreiskapazitäten in Form kapazitiver Speicherelemente 31, 32, beispielsweise Kondensatoren, geschaltet. Die Schwingkreise 1, 2 gemäß Figur 4 sind indirekt über die Primärwicklungen 11, 21 der Übertrager gekoppelt, indem das Kopplungselement 33 zwischen diese Primärwicklungen 11, 21 geschaltet ist. Alternativ besteht die Möglichkeit, die beiden Schwingkreise 1, 2 direkt miteinander zu koppeln, indem das Kopplungselement sekundärseitig zwischen die Schwingkreise geschaltet wird, was in Figur 4 gestrichelt dargestellt ist.

Wie bei dem Signalübertrager gemäß Figur 1 dienen die Anschlüsse 14, 24 des Signalübertragers gemäß Figur 4 zum Anschließen der Anregungsschaltungen (nicht dargestellt).

Bei dem Signalübertrager gemäß Figur 1 sind die Anregungsschaltungen unmittelbar an die primärseitig realisierten Schwingkreise 1, 2 angeschlossen, die Anregung dieser Schwingkreise erfolgt somit direkt durch die Anregungsschaltungen. Bei dem Signalübertrager gemäß Figur 4 erfolgt eine Anregung der sekundärseitig realisierten Schwingkreise 1, 2 durch die an die Anschlüsse 14, 24 anschließbaren Anregungsschaltungen indirekt über die Primärwicklungen 11, 21 der Übertrager. Figur 5 zeigt ein Ausführungsbeispiel eines Signalübertragers mit primärseitig angeordneten Schwingkreisen 1, 2, die als Schwingkreisinduktivitäten jeweils die Primärwicklungen der Übertrager enthalten und die indirekt angeregt werden. Zur Anregung dieser Schwingkreise 1, 2 sind Anregungswicklungen 17, 27 vorhanden, von denen jeweils eine induktiv mit einer Primärwicklung 11, 21 - und damit auch induktiv mit einer Sekundärwicklungen 12, 22 - gekoppelt ist. Je eine der Anregungswicklungen 17, 27 ist zwischen die Klemme für das primärseitige Bezugspotential REF1 und einen der Anschlüsse 14, 24 für die Anregungsschaltungen (nicht dargestellt) geschaltet.

Anstelle der zuvor anhand der Figuren 1, 4 und 5 erläuterten Parallelschwingkreise der Signalübertrager können selbstverständlich auch Serienschwingkreise verwendet werden, die dadurch erhalten werden, dass die Schwingkreiskapazitäten nicht parallel, sondern in Reihe zu den Schwingkreisinduktivitäten geschaltet sind.

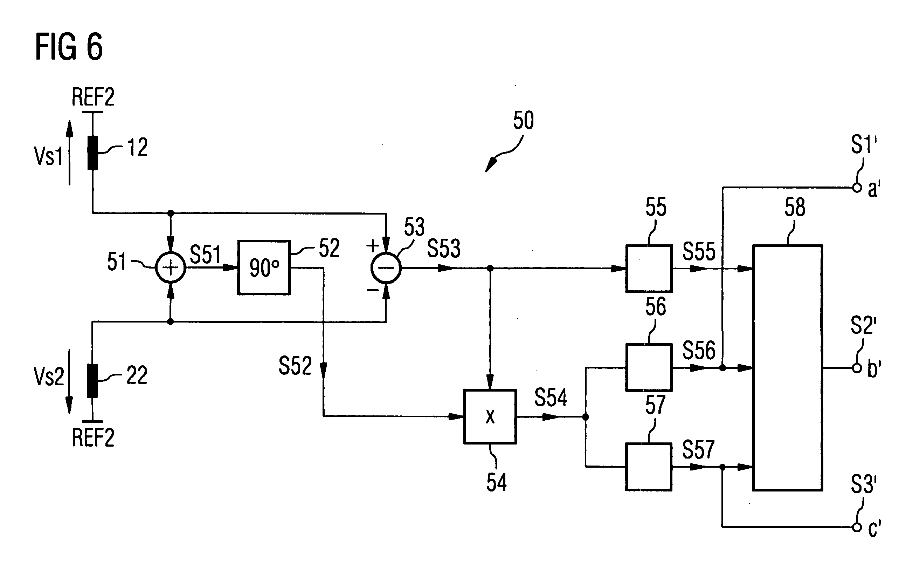

Eine Empfangsschaltung bzw. Demodulationsschaltung 50 zur Ermittlung der Phasenbeziehung zwischen den an der ersten Sekundärwicklung 12 anliegenden ersten Sekundärspannung Vs1 und der an der zweiten Sekundärwicklung 22 anliegenden zweiten Sekundärspannung Vs2, ist in Figur 6 dargestellt. Diese Sekundärspannungen sind nachfolgend als erste und zweite Empfangssignale bezeichnet. Zum besseren Verständnis sind in Figur 6 lediglich die Sekundärwicklungen 12, 22 des Signalübertragers dargestellt, der einer der zuvor anhand der Figuren 1, 4 und 5 erläuterten Signalübertrager sein kann. Die Demodulationsschaltung 50 weist ein Additionsglied 51 und ein Subtraktionsglied 53 auf, denen die ersten und zweiten Empfangssignale Vs1, Vs2 jeweils zugeführt sind. Dem Subtrahierer 53 ist das erste Empfangssignal Vs1 mit positivem Vorzeichen und das zweite Empfangssignal Vs2 mit negativem Vorzeichen zugeführt. Am Ausgang des Addierers 51 steht ein Summensignal S51 zur Verfügung, dass der Summe der ersten und zweiten Empfangssignale 12, 22 entspricht. Unter dem Addierer 51 ist im Zusammenhang mit der vorliegenden Erfindung eine beliebige Anordnung zu verstehen, die geeignet ist, die beiden Empfangssignale 12, 22 zu addieren. Unter einer Addition kann hierbei auch eine gewichtete Addition der beiden Empfangssignale Vs1, Vs2 mit unterschiedlichen Gewichtungsfaktoren verstanden werden.

Unter dem Subtrahierer 53 ist eine beliebige Anordnung zu verstehen, die geeignet ist, das zweite Signal Vs2 von dem ersten Signal Vs1 zu subtrahieren. Unter einer Subtraktion kann hierbei auch eine gewichtete Subtraktion der beiden Empfangssignale Vs1, Vs2 mit unterschiedlichen Gewichtungsfaktoren verstanden werden.

Dem Addierer 51 ist ein Phasenschieber 52 nachgeschaltet, der aus dem am Ausgang des Addierers 51 Summensignal S51 ein phasenverschobenes Summensignal S53 erzeugt, dessen Phase um einen vorgegebenen Wert gegenüber der Phase des Summensignals S51 verschoben ist. Die durch diesen Phasenschieber 52 bewirkte Phasenverschiebung beträgt für die dargestellte Demodulationsschaltung idealerweise 90°. Diese Phasenverschiebung kann grundsätzlich jedoch im Bereich zwischen 60° und 120° liegen.

Das Differenzsignal S53 sowie das phasenverschobene Summensignal S52 sind einem Mischer 54 zugeführt, an dessen Ausgang ein Mischsignal S54 zur Verfügung steht. Dem Mischer 54 ist eine Auswerteschaltung 55-58 nachgeschaltet, die dazu ausgebildet ist, aus dem Mischsignal S54 unter Berücksichtigung des Differenzsignals S53 demodulierte Signale S1', S2', S3' zu erzeugen. Bei einer störungsfreien Übertragung entspricht das erste Demodulationssignal S1' dem ersten Steuersignal S1, das zweite Demodulationssignal S2' dem zweiten Steuersignal S2 und das dritte Demodulationssignal S3 dem dritten Steuersignal. Mit a', b', c' sind in Figur 6 Empfangssymbole bezeichnet, die je einem der Empfangssignale S1', S2', S3' zugeordnet sind und die bei einer störungsfreien Übertragung den Sendesymbolen a, b, c entsprechen.

Abhängig von der Phasenverschiebung der ersten und zweiten Empfangssignale Vs1, Vs2, und damit abhängig von dem übertragenen Sendesymbol a, b, c stehen bei dem in Figur 6 dargestellten Demodulator 50 am Ausgang des Mischer 54 unterschiedliche Mischsignale S54 zur Verfügung, die durch die nachgeschaltete Auswerteschaltung 55-58 ausgewertet werden.

Es lässt sich zeigen, dass unabhängig von der Phasenverschiebung zwischen dem ersten und zweiten Empfangssignal Vs1, Vs2 unter Annahme einer gleichen Frequenz dieser ersten und zweiten Empfangssignale Vs1, Vs2, das Summensignal S51 und das Differenzsignal S53 Signale gleicher Frequenz jedoch mit unterschiedlicher Phase sind. Entsprechend besitzen das Differenzsignal S53 und das phasenverschobene Summensignal S52 unterschiedliche Phasen. Es lässt sich außerdem zeigen, dass bei einer Phasenverschiebung zwischen dem ersten und zweiten Signal Vs1, Vs2 von 90°, also dann, wenn die Phase des zweiten Signals Vs2 der Phase des ersten Signals Vs1 um 90° vorauseilt, das Differenzsignal S53 und das phasenverschobene Summensignal S52 gegenphasige Signale sind, während bei einer Phasenverschiebung zwischen dem ersten und zweiten Signal Vs1, Vs2 von 270° bzw. -90° das Differenzsignal S53 und das phasenverschobene Summensignal S52 gleichphasige Signale sind. Das Ausgangssignal S54 des Mischers 54 bei einer Phasenverschiebung von 90° unterscheidet sich somit im Vorzeichen vom Ausgangssignal S54 des Mischers 54 bei einer Phasenverschiebung von 270°. Ein erster dem Mischer 54 nachgeschalteter Schwellenwertdetektor 56 vergleicht das Mischsignal S54 mit einem vorgegebenen negativen Schwellenwert, während ein zweiter dem Mischer 54 nachgeschalteter Schwellenwertdetektor 57 das Mischsignal S54 mit einem vorgegebenen positiven Schwellenwert vergleicht. Liegt das Mischsignal S54 unter dem negativen Schwellenwert, wird von einer Phasenverschiebung zwischen dem ersten und zweiten Signal Vs1, Vs2 von 90°, d. h. von einem gesendeten Informationssymbol a ausgegangen. Am Ausgang des ersten Schwellenwertdetektors 56 liegt in diesem Fall ein Signalpegel für das erste Demodulationssignal a' an, der auf ein gesendetes Sendesymbol a hinweist. Dieser Signalpegel ist beispielsweise ein High-Pegel.

Liegt das Mischsignal S54 oberhalb des positiven Schwellenwertes, so wird von einer Phasenverschiebung zwischen dem ersten und zweiten Signal Vs1, Vs2 von 270° und damit von einem gesendeten Informationssymbol c ausgegangen. Am Ausgang des zweiten Schwellenwertdetektors 57 liegt dann ein auf Sendesymbol c hinweisender Pegel für das dritte Demodulationssignal c' an.

Bei einer Phasenverschiebung zwischen dem ersten und zweiten Signal Vs1, Vs2 von 180° ist das Summensignal S51, und damit auch das phasenverschobene Signal S52 gleich Null. Entsprechend ist auch das Mischsignal S54 gleich Null. Eine solche Phasenverschiebung von 180° zwischen dem ersten und zweiten Signal Vs1, Vs2 wird unter Verwendung des Differenzsignals S53 detektiert. Ein Signaldetektor 55, dem dieses Differenzsignal S53 zugeführt ist, detektiert, ob die Amplitude des Differenzsignals S53 ungleich Null ist. Das Ausgangssignal dieses Signalsdetektors 55 sowie die Ausgangssignale der beiden Schwellenwertdetektoren 56, 57 sind einer Logikeinheit 58 zugeführt, an deren Ausgang das zweite Demodulationssignal b' zur Verfügung steht. Die Logikeinheit ist derart realisiert, dass das Demodulationssignal S2 bzw. des Empfangssymbol b' dann einen High-Pegel annimmt, wenn der Signaldetektor 55 eine Amplitude des Differenzsignals S53 ungleich Null detektiert, wenn das Mischsignal S54 jedoch den positiven Schwellenwert nicht überschreitet und den negativen Schwellenwert nicht unterschreitet.

Zur Ermittlung des zweiten Demodulationssignals b' wird somit ein Ausschlusskriterium angewendet. Von einer Phasenverschiebung von 180° zwischen dem ersten und zweiten Empfangssignal Vs1, Vs2 wird also dann ausgegangen, wenn das Differenzsignal S53 eine Amplitude ungleich Null besitzt, wenn jedoch die Ausgangssignale des ersten und zweiten Schwellenwertdetektors 56, 57 nicht auf eine Phasenverschiebung von +90° oder -90° hinweisen. Unter der Annahme, dass das Ausgangssignal S55 des Signaldetektors 55 einen High-Pegel annimmt, wenn die Amplitude des Differenzsignals S53 ungleich Null ist, dass das Ausgangssignal S56 des ersten Schwellenwertdetektors 56 einen High-Pegel annimmt, wenn das Mischsignal S54 unterhalb des negativen Schwellenwertes liegt, und dass das Ausgangssignal S57 des zweiten Schwellenwertdetektors 57 einen High-Pegel annimmt, wenn das Mischsignal S54 oberhalb des positiven Schwellenwertes liegt, gilt für die Empfangssymbole a', b', c':

$$a' = S56 \tag{4a}$$

$$b' = S55 \text{ (AND NOT (S56 OR S57)} \tag{4b}$$

$$c' = S57 \tag{4c}.$$

Die Funktionsweise der in Figur 6 dargestellten Demodulationsschaltung wird nachfolgend für sinusförmige Empfangssignale Vs1, Vs2 erläutert. Zur Vereinfachung der Erläuterung wird angenommen, dass diese Signale gleiche Amplituden besitzen. Bei einem übertragenen Sendesymbol a, also bei einer Phasenverschiebung zwischen dem ersten und zweiten Signal Vs1, Vs2 von 90° gilt für das Summensignal 51, das phasenverschobene Summensignal S52, das Differenzsignal S53 und das Mischsignal S54:

$$S51 = \sin \omega t + \sin(\omega t + 90°) = 2\sin\frac{2\omega t + 90°}{2}\cdot\cos(-45°) = \sqrt{2}\sin\frac{2wt+90°}{2} \tag{5a}$$
$$= \sqrt{2}\sin(\omega t + 45°)$$

$$S52 = \sqrt{2}\sin(\omega t + 135°) \tag{5b}$$

$$S53 = \sin \omega t - \sin(\omega t + 90°) = 2\cos\frac{2\omega t + 90°}{2}\cdot\sin(-45°) = -\sqrt{2}\cos(wt + 45°) \tag{5c}$$
$$= -\sqrt{2}\sin(\omega t + 135°)$$

$$S54 = -2\cdot\sin^2(\omega t + 135°) = -1 + \cos(2\omega t + 270°) \tag{5d}.$$

Bei dieser Phasenverschiebung von 90° sind das phasenverschobene Summensignal S52 und das Differenzsignal S53 somit gegenphasige Signale gleicher Frequenz. Das Mischsignal S54 besitzt einen negativen Gleichanteil und einen positiven sinusförmigen Schwingungsanteil. Der erste Schwellenwertdetektor 56 ist dabei so realisiert, dass er lediglich den negativen Gleichanteil des Mischsignals S54 auswertet und mit dem negativen Schwellenwertsignal vergleicht. Der Schwellenwertdetektor 56 kann zu diesem Zweck derart realisiert sein, dass er den Mittelwert des Mischsignals S54 bildet und den Mittelwert des Mischsignals mit dem negativen Schwellenwert vergleicht. Schaltungstechnisch einfacher zu realisieren ist jedoch ein Schwellenwertdetektor 56, der so träge ist, dass er Änderungen des Mischsignals S54 mit der Frequenz $2\omega$t nicht folgt. Der Schwellenwertdetektor 56 wertet in diesem Fall effektiv nur den negativen Gleichanteil des Mischsignals S54 aus.

Bei einer Phasenverschiebung von 270° bzw. -90° zwischen dem ersten und zweiten Signal Vs1, Vs2 gilt für das Summensignal S51, das phasenverschobene Summensignal S52, das Differenzsignal S53 und das Mischsignal S54:

$$S51 = \sin \omega t + \sin(\omega t + 270°) = 2\sin\frac{2\omega t + 270°}{2}\cdot\cos{-135°} \tag{6a}$$
$$= -\sqrt{2}\sin\frac{(2\omega t + 270°)}{2} = -\sqrt{2}\sin(\omega t + 135°)$$

$$S52 = \sqrt{2}\sin(\omega t + 225°) \tag{6b}$$

$$S53 = \sin \omega t - \sin(\omega t + 270°) = 2\cos\frac{2\omega t + 270°}{2}\cdot\sin{-135°} = -\sqrt{2}\cos(wt + 135°) \tag{6c}$$
$$= \sqrt{2}\sin(\omega t + 225°)$$

$$S54 = 2\sin^2(\omega t + 225°) = 1 + \cos(2\omega t + 90°) \tag{6d}.$$

Das phasenverschobene Summensignal S52 und das Differenzsignal S53 sind in diesem Fall also gleichphasige Signal gleicher Frequenz. Das Mischsignal S54 besitzt in diesem Fall einen positiven Gleichanteil und einen positiven Schwingungsanteil. Entsprechend des Schwellenwertdetektors 56 ist der Schwellenwertdetektor 57 dazu ausgebildet, lediglich den Gleichanteil des Mischsignals S54 auszuwerten und diesen Gleichanteil mit dem positiven Schwellenwert zu vergleichen.

Bei einer Phasenverschiebung zwischen dem ersten und zweiten Signal Vs1, Vs2 von 180° gilt für das Additionssignal S51, das phasenverschobene Additionssignal S52:

$$S51 = \sin \omega t + \sin(\omega t + 180°) = 0 \qquad (7a)$$

$$S52 = 0 \qquad (7b)$$

$$S53 = \sin \omega t - win(\omega t + 180°) = 2 \cos \frac{2\omega t + 180°}{2} \cdot \sin(-90°) \qquad (7c)$$

$$S54 = 0 \qquad (7d).$$

Das Differenzsignal S53 besitzt hierbei eine Amplitude ungleich Null, während das Mischsignal S54 in bereits erläuterter Weise gleich Null ist.

Die in Figur 6 dargestellte Demodulationsschaltung 50 ist somit in der Lage, drei unterschiedliche Phasenbeziehungen der ersten und zweiten Signale Vs1, Vs2 zu detektieren und Demodulationssignale S1', S2', S3' bzw. Empfangssymbole a', b', c' zu erzeugen, die abhängig von diesen Phasenverschiebungen sind.

Bei der in Figur 6 dargestellten Demodulationsschaltung 50 sind Schwellenwertdetektoren 56, 57 erforderlich, die das Ausgangssignal S54 des Mischers 54 mit einem negativen bzw. einem positiven Schwellenwert vergleichen. Dieser Schwellenwert ist dabei abhängig von der Amplitude der Empfangssignale Vs1, Vs2.

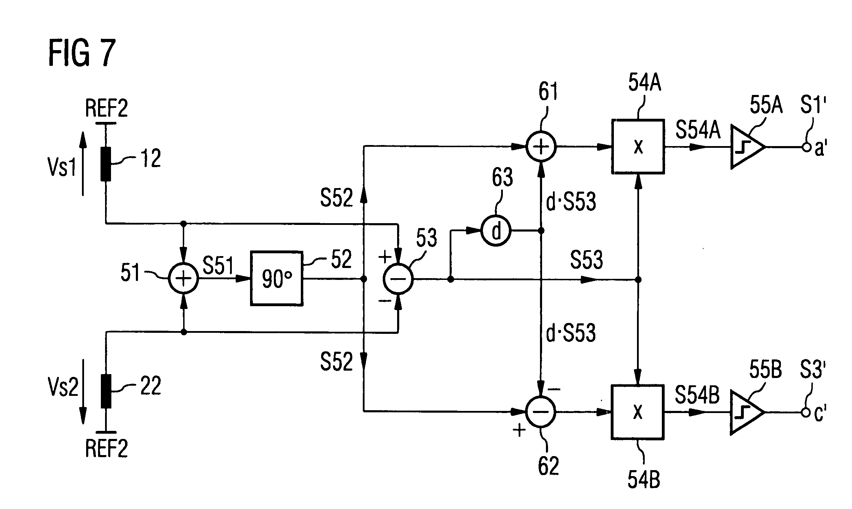

Figur 7 zeigt ein Ausführungsbeispiel einer Demodulationsschaltung, bei der die Auswertung der Phasenbeziehung zwischen dem ersten und zweiten Empfangssignal Vs1, Vs2 unabhängig von der Amplitude dieser Signale ist. Bei dieser Demodulationsschaltung sind zwei Mischer 54A, 54B vorhanden, denen jeweils das Differenzsignal S53 zugeführt ist. Ausgangssignale S54A, S54B dieser Mischer 54A, 54B sind den Mischern 54A, 54B nachgeschalteten Schwellenwertdetektoren 55A, 55B zugeführt. Diese Schwellwertdetektoren müssen dabei lediglich in der Lage sein, Vorzeichen des jeweiligen Ausgangssignals S54A, S54B der Mischer 54A, 54B auszuwerten.

Am Ausgang des ersten Schwellenwertdetektors 55A steht bei diesem Demodulator 50 das erste Demodulationssignal S1 bzw. das erste Empfangssymbol a' und am Ausgang des zweiten Schwellenwertdetektors 55B steht das dritte Demodulationssignal S3 bzw. das dritte Empfangssymbol c' zur Verfügung. Der erste Schwellenwertdetektor 55A ist dazu ausgebildet, einen High-Pegel des ersten Demodulationssignals S1 zu erzeugen, wenn das Ausgangssignal S54A des ersten Mischers ein negatives Vorzeichen besitzt bzw. wenn der Gleichanteil dieses ersten Mischerausgangssignals S54A ein negatives Vorzeichen besitzt. Der zweite Schwellenwertdetektor 55B ist dazu ausgebildet, einen High-Pegel des dritten Demodulationssignals S3' zu erzeugen, wenn das Ausgangssignal S54B des zweiten Mischers 54B ein positives Vorzeichen besitzt bzw. wenn der Gleichanteil dieses zweiten Mischerausgangssignals S54B ein positives Vorzeichen besitzt.

Dem weiteren Eingang des ersten Mischers 54A ist ein Summensignal zugeführt, welches sich aus dem phasenverschobenen Summensignal S52 und einem gedämpften Differenzsignal d·S53, mit d<1, ergibt. Dieses Summensignal steht am Ausgang eines weiteren Addierers 61 zur Verfügung, dem das phasenverschobene Summensignal S52 und das gedämpfte Differenzsignal d·S53 zugeführt sind. Das gedämpfte Differenzsignal d.S53 steht am Ausgang eines Verstärkers 63 mit einer Verstärkung d<1 zur Verfügung.

Dem weiteren Eingang des zweiten Mischers 54B ist ein Differenzsignal zugeführt, das am Ausgang eines weiteren Subtrahierers 62 zur Verfügung steht, dem das phasenverschobene Summensignal S52 mit positivem Vorzeichen und das gedämpfte Differenzsignal d.S53 mit negativem Vorzeichen zugeführt ist.

Für das erste Mischerausgangssignal S54A gilt bei dieser Anordnung:

$$S54A = S53 \cdot (d \cdot S53 + S52) = S52 \cdot S53 + d \cdot S53^2 \qquad (8a).$$

Für das Ausgangssignal S54B des zweiten Mischers 54B gilt entsprechend:

$$S54B = S53 \cdot (S52 - d \cdot S53) = S52 \cdot S53 - d \cdot S53^2 \qquad (8b).$$

Das erste Mischerausgangssignal S54A unterscheidet sich von dem Ausgangssignal S54 der Demodulationsschaltung gemäß Figur 6 durch einen positiven Offset $d.S53^2$, der sich aus dem Quadrat des Differenzsignals S53 multipliziert mit dem Dämpfungsfaktor d ergibt. Der Dämpfungsfaktor d ist dabei so gewählt, dass bei einer Phasenverschiebung zwischen dem ersten und zweiten Empfangssignal Vs1, Vs2 von 90° der Gleichanteil der Mischerausgangssignals S54A noch kleiner Null ist, bei einer Phasenverschiebung von 180° der Gleichanteil des Mischerausgangssignals S54A jedoch sicher größer als Null ist. Am Ausgang des ersten Schwellenwertdetektors 55A liegt somit nur dann ein High-Pegel für das erste Demodulationssignal S1' an, wenn die Phasenverschiebung zwischen dem ersten und zweiten Empfangssignal Vs1, Vs2 zwischen 60° und 120°, idealerweise 90°, beträgt. Bei einer Phasenverschiebung zwischen dem ersten und zweiten Empfangssignal Vs1, Vs2 von 270° ist bereits das Produkt aus dem phasenverschobenen Summensignal S52 und dem Differenzsignal S53 größer als Null (vgl. Gleichung 6d), so dass bei dieser Phasenverschiebung das Ausgangssignal des ersten Schwellenwertdetektors 55A sicher Null ist.

Das Ausgangssignal S54B des zweiten Mischers 54B unterscheidet sich von dem Mischerausgangssignal S54 der Demodulationsschaltung in Figur 6 durch einen negativen Offset $-d.S53^2$. Dieser negative Offset führt bei einer Phasenverschiebung von 270° dazu, dass das Ausgangssignal S54B des zweiten Mischers 54B kleiner ist als das Ausgangssignal des Mischers S54 in Figur 6. Der Dämpfungsfaktor d ist dabei so gewählt, dass das Mischerausgangssignal S54B jedoch sicher größer als Null ist. Bei einer Phasenverschiebung von 180° führt der negative additive Offset $-d.S53^2$ dazu, dass das Mischerausgangssignal S54B des zweiten Mischers 54B sicher kleiner als Null ist. Am Ausgang des zweiten Schwellenwertdetektors 55B steht somit nur dann ein High-Pegel für das dritte Demodulationssignal S3 zur Verfügung, wenn die Phasenverschiebung zwischen dem ersten und zweiten Empfangssignal Vs1, Vs2 zwischen 240° und 300°, idealerweise 270°, beträgt.

In Figur 7 aus Gründen der Übersichtlichkeit nicht näher dargestellt ist der Signaldetektor 55 und die Logikschaltung 58, die aus dem ersten und dritten Demodulationssignal S1', S3' bzw. dem ersten und dritten Empfangssymbol a', c' das zweite Demodulationssignal b' mittels des bereits zuvor anhand von Gleichung 4b erläuterten Ausschlusskriteriums ermitteln.

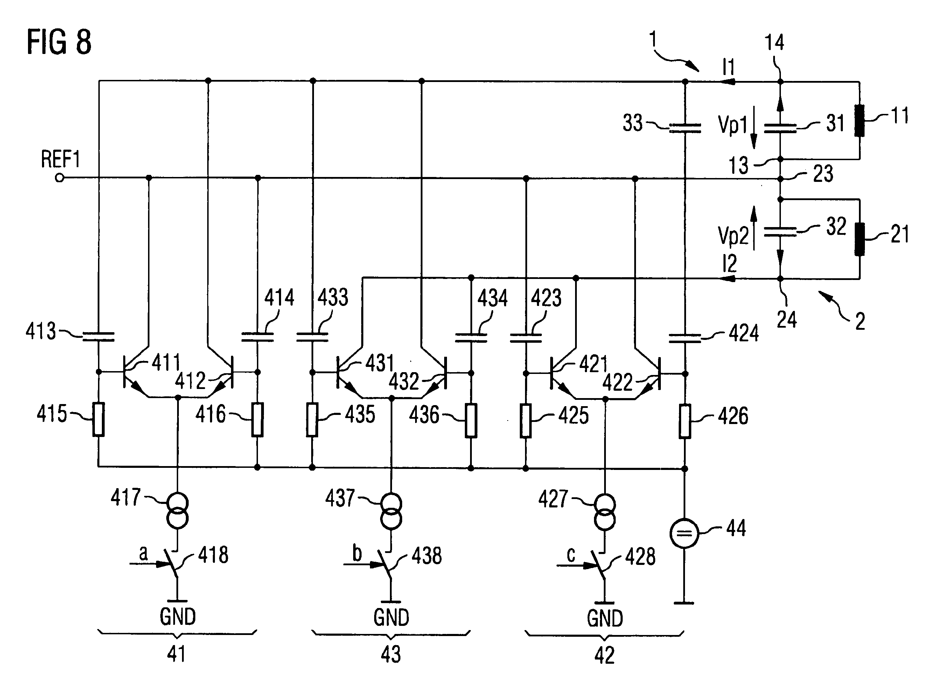

Ein Realisierungsbeispiel der Anregungsschaltungen 41, 42, 43, die abhängig von den zu übertragenden Sendesymbolen a, b, c die Schwingkreise 11, 31 bzw. 21, 32 zu Schwingungen mit unterschiedlichen Phasenbeziehungen anregen, ist in Figur 8 dargestellt. Jede dieser Anregungsschaltungen weist eine steuerbare Stromquelle 417, 427, 437 auf, die durch das jeweilige Steuersignal S1, S2, S3 gesteuert, d. h. im vorliegenden Fall ein- oder ausgeschaltet, wird. Die Steuerung der Stromquellen 417, 427, 437, die nachfolgend als erste bis dritte Stromquelle bezeichnet werden, erfolgt bei dem in Figur 6 dargestellten Beispiel durch Schalter 418, 428, 438, die jeweils in Reihe zu den Stromquellen 417, 427, 437 geschaltet sind und die durch die Steuersignale S1, S2, S3 ein- oder ausgeschaltet werden. Ein eingeschalteter Schalter 418, 428, 438 aktiviert hierbei die jeweilige Stromquelle 417, 427, 437 ein, während ein ausgeschalteter Schalter 418, 428, 438 die jeweilige Stromquelle 417, 427, 437 deaktiviert.

Die Anregung des ersten Schwingkreises 1 erfolgt bei der dargestellten Schaltung durch die erste Anregungsschaltung 41 mittels eines ersten Anregungsstromes I1 an dem Anschluss 14 dieses Schwingkreises 1. Die Stromstärke des ersten Anregungsstromes I1 variiert zwischen einem oberen Signalpegel, der in dem Beispiel der Stromstärke des durch die Stromquelle 417 gelieferten Stromes entspricht, und einem unteren Signalpegel, der in dem Beispiel Null entspricht. Der erste Anregungsstrom I1 besitzt einen annähernd rechteckförmigen Signalverlauf, der von der Spannung Vp1 über dem ersten Schwingkreis 1 abhängig ist. Bei der in Figur 8 dargestellten Schaltung variiert der Signalpegel des ersten Anregungsstromes I1 abhängig von der Polung der Schwingkreisspannung Vp1. Bei einer negativen Spannung Vp1 zwischen dem zweiten und ersten Anschluss 14, 13 nimmt der Anregungsstrom I1 seinen oberen Signalpegel an, um die Schwingung zu verstärken, und bei einer positiven Spannung Vp1 zwischen dem zweiten und ersten Anschluss 14, 13 nimmt der Anregungsstrom I1 seinen unteren Signalpegel an, um die Schwingung nicht zu dämpfen.

Der gepulste erste Anregungsstrom I1 wird bei aktivierter erster Stromquelle 417 mittels einer Umschaltvorrichtung 411-416 aus dem durch diese Stromquelle 417 bereitgestellten Strom erzeugt. Die Stromquelle 417 wird hierzu durch die Umschaltvorrichtung 411-416 abhängig von der Polung der Schwingkreisspannung Vp1 an den zweiten Anschluss 14 angeschlossen, was einem oberen Signalpegel des ersten Anregungsstromes I1 entspricht, oder an den ersten Anschluss 13 des Schwingkreises angeschlossen. Der erste Anschluss 13 des Schwingkreises 1 ist an die Klemme für das erste primärseitige Bezugspotential REF1, das beispielsweise ein positives Versorgungspotential mit Werten zwischen 5V und 20V ist. Bei Anschließen der ersten Stromquelle 417 an den ersten Anschluss 13 des Schwingkreise fließt unmittelbar ein Strom von der Klemme für das Versorgungspotential REF1 an das Bezugspotential GND; der Anregungsstrom I1 ist dadurch Null.

Die Umschaltvorrichtung 411-416 weist zwei Transistoren 411, 412 auf, die die Funktion von Schaltelementen haben und die in dem Beispiel als Bipolartransistoren realisiert sind. Die Laststrecke (Kollektor-Emitter-Strecke) eines ersten 411 der Transistoren ist hierbei zwischen den ersten Anschluss 13 des ersten Schwingkreises 1 und die erste Stromquelle 417 geschaltet, und die Laststrecke eines zweiten der Transistoren ist zwischen den zweiten Anschluss 14 des ersten Schwingkreises 1 und die erste Stromquelle 417 geschaltet.

Die Transistoren 411, 412 sind gleichzeitig Teil einer Vergleicheranordnung, die die Polung der Schwingkreisspannung Vp1 ermittelt und die abhängig von dieser Polung einen der beiden Transistoren 411, 412 ansteuert. Der Steueranschluss (Basisanschluss) des ersten Transistors 411 ist hierbei an den zweiten Anschluss 14 des Schwingkreises gekoppelt, während der Steueranschluss des zweiten Transistors 412 an den ersten Anschluss des ersten Schwingkreises 1 gekoppelt ist.

Kondensatoren 413, 414 zwischen den Basisanschlüssen der Transistoren 411, 412 und den Anschlüssen 13, 14 des Schwingkreises 1 dienen zur kapazitiven Entkopplung der Basispotentiale dieser Transistoren von den Potentialen an den Schwingkreisanschlüssen 13, 14. Zur Einstellung der Arbeitspunkte der beiden Transistoren 411, 412 sind Widerstände 415, 416 vorhanden, die zwischen die Basisanschlüsse dieser Transistoren 411, 412 und eine Referenzpotentialquelle 44 geschaltet sind. Die von dieser Referenzpotentialquelle 44 gelieferte Spannung dient zur Einstellung des Arbeitspunktes der beiden Transistoren 411, 412. Von den beiden Transistoren 411, 412 ist nur jeweils einer leitend angesteuert, und zwar derjenige der beiden Transistoren, dessen Basis an den Schwingkreisanschluss 13, 14 angeschlossen ist, der sich momentan auf positivem Potential befindet. Während der positiven Halbwelle der Schwingung, wenn die Schwingkreisspannung Vp1 positiv ist, leitet der erste Transistor 411 und schließt damit die Stromquelle 417 an den ersten Schwingkreisanschluss 413 an. Während der negativen Halbwelle, wenn das Potential an dem ersten Schwingkreisanschluss 13 größer als an dem zweiten Schwingkreisanschluss 14 ist, leitet der zweite Transistor 412 und schließt damit die Stromquelle 417 an den zweiten Schwingkreisanschluss 14 an.

Die Anregung des zweiten Schwingkreises 2 durch die zweite Anregungsschaltung 42 erfolgt entsprechend der Anregung des ersten Schwingkreises 1 durch die erste Anregungsschaltung 41. Die zweite Anregungsschaltung 42 erzeugt einen gepulsten zweiten Anregungsstrom I2 an dem zweiten Schwingkreisanschluss 24 abhängig von der Polarität der Schwingkreisspannung Vp2 dieses zweiten Schwingkreises. Während einer positiven Halbwelle, wenn diese Spannung Vp2 positiv ist, ist der zweite Anregungsstrom I2 Null. Während dieser Schwingungsphase ist die zweite Stromquelle 427 über einen zweiten Transistor 422 einer zweiten Umschalteinrichtung 421-426 an das Versorgungspotential REF1 an dem ersten Schwingkreisanschluss 23 angeschlossen. Die Basis dieses zweiten Transistors 422 ist hierbei über eine Kapazität 424 an den zweiten Schwingkreisanschluss 24 angeschlossen. Während einer negativen Halbwelle der Schwingung, also bei einer negativen Spannung Vp2, ist die Stromquelle 427 über einen ersten Transistor 421 der Umschalteinrichtung an den zweiten Anschluss 24 des Schwingkreises angeschlossen, wodurch der zweite Anregungsstrom I2 einen oberen Signalpegel annimmt. Der Basisanschluss des ersten Transistors 421 ist hierbei über einen Kondensator 423 an den ersten Schwingkreisanschluss 23 angeschlossen. Zur Einstellung der Arbeitspunkte der Bipolartransistoren 421, 422 sind deren Basisanschlüsse über Widerstände 425, 426 an die Referenzspannungsquelle 44 angeschlossen.

Die dritte Anregungsschaltung 43 zur gegenphasigen Anregung der beiden Schwingkreise 1, 2 ist entsprechend der ersten und zweiten Anregungsschaltung 41, 42 realisiert und weist eine dritte Stromquelle 437 sowie eine Umschaltvorrichtung 431-436 auf, die dazu dient, die Stromquelle 437 entweder über einen ersten Transistor 431 an den zweiten Anschluss 24 des zweiten Schwingkreises 2 oder über einen zweiten Transistor 432 an den zweiten Anschluss 14 des ersten Schwingkreises 1 anzuschließen. Die Ansteuerung dieser beiden Transistoren 431, 432 erfolgt abhängig von den Potentialen an diesen zweiten Schwingkreisanschlüssen 14, 24. Der erste Transistor 431 ist hierbei an den zweiten Anschluss 14 des ersten Schwingkreises 1 gekoppelt, während der Basisanschluss des zweiten Transistors 432 an den zweiten Anschluss 24 des zweiten Schwingkreises 2 gekoppelt ist. Der erste Transistor 431 leitet bei einer positiven Halbwelle der Schwingung des ersten Schwingkreises 1, um während dieser Phase die Schwingung des zweiten Schwingkreises, die dann eine negative Halbwelle aufweist, zu verstärken. Der zweite Transistor 432 leitet während der positiven Halbwelle der Schwingung des zweiten Schwingkreises 2, um während dieser Phase die Schwingung des ersten Schwingkreises 1, die dann eine negative Halbwelle aufweist, zu verstärken.

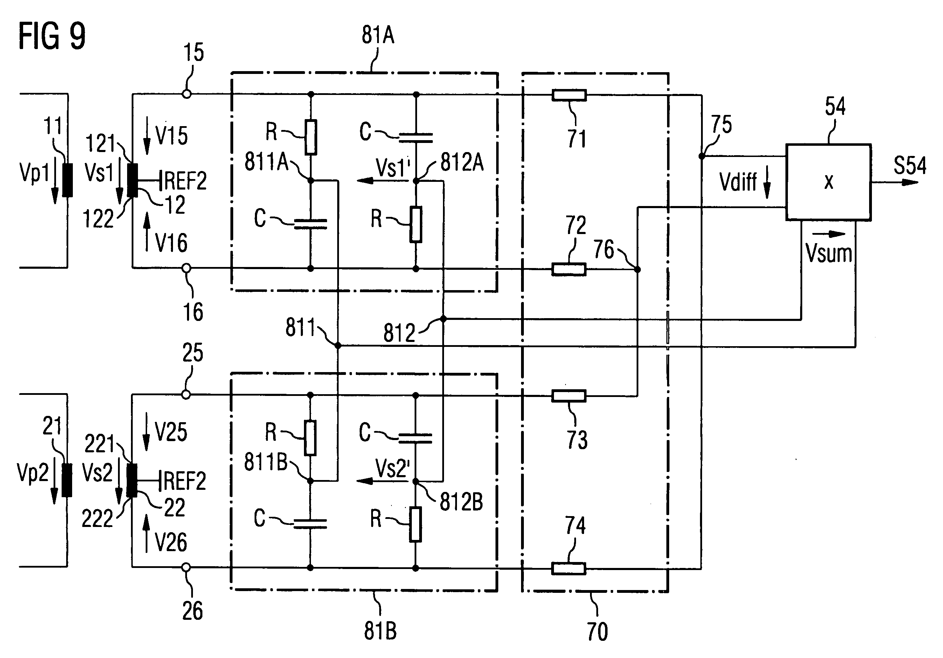

Figur 9 zeigt ein Ausführungsbeispiel der Demodulationsschaltung 50, die dieselbe Funktion wie die in Figur 6 dargestellte Demodulationsschaltung erfüllt und die Additionen, Subtraktionen und Phasenverschiebungen ausschließlich unter Verwendung passiver Bauelemente, im vorliegenden Fall unter Verwendung von Widerständen und Kondensatoren, ausführt. Die Sekundärwicklungen 12, 22, über denen die Sekundärspannungen Vs1, Vs2 anliegen weisen in dem dargestellten Beispiel jeweils zwei Wicklungsabschnitte 121, 122 bzw. 221, 222 auf. Die Wicklungsabschnitte 121, 122 bzw. 221, 222 einer Sekundärwicklung 12, 22 sind dabei jeweils induktiv mit der zugehörigen Primärwicklung 11, 21 des jeweiligen Übertragers 12, 20 gekoppelt. Die Wicklungsabschnitte 121, 122 bzw. 221, 222 einer Sekundärwicklung 12, 22 besitzen einen zueinander entgegengesetzten Wicklungssinn und sind mit einem Anschluss jeweils an das sekundärseitige Bezugspotential REF2 angeschlossen. Anschlüsse der Wicklungsabschnitte 121, 122 bzw. 221, 222, die dem Anschluss für das sekundärseitige Bezugspotential REF2 abgewandt sind, bilden Anschlüsse 15, 16 bzw. 25, 26 der Sekundärwicklungen 12, 22, an denen die Sekundärspannungen Vs1, Vs2 abgreifbar sind. Für Spannungen V15, 16 zwischen dem ersten und zweiten Anschluss 15, 16 der ersten Sekundärwicklung 12 gegen das sekundärseitige Bezugspotential REF2 gilt hierbei:

$$V16 = -V15. \qquad (9a)$$

Entsprechend gilt für Spannungen V25, 26 zwischen dem ersten und zweiten Anschluss 25, 26 der zweiten Sekundärwicklung 22 gegen das sekundärseitige Bezugspotential REF2:

$$V26 = -V25. \qquad (9b)$$

Eine Differenzspannung Vdiff, für die Vdiff = 0,5·(Vs1 - Vs2) gilt, wird bei der in Figur 9 dargestellten Demodulationsschaltung durch ein Widerstandsnetzwerk 70 erzeugt. Dieses Widerstandsnetzwerk 70 besitzt zwei Schaltungsknoten 75, 76, zwischen denen die Differenzspannung Vdiff anliegt. Ein erster Anschluss 15 der ersten Sekundärwicklung 12 ist dabei über einen ersten Widerstand 71 an den ersten Schaltungsknoten 75 des Widerstandsnetzwerk 70 angeschlossen, und ein zweiter Anschluss 16 der ersten Sekundärwicklung 12 ist über einen zweiten Widerstand 72 an den zweiten Schaltungsknoten 76 des Widerstandsnetzwerkes 70 angeschlossen. Entsprechend ist ein erster Schaltungsknoten 25 der zweiten Sekundärwicklung 22 über einen dritten Widerstand 73 an den ersten Schaltungsknoten 75 des Widerstandsnetzwerkes 70 angeschlossen, und ein zweiter Anschluss 26 der zweiten Sekundärwicklung 22 ist über einen vierten Widerstand 74 an den zweiten Anschluss 76 des Widerstandsnetzwerkes 70 angeschlossen.

Der Mischer 54 besitzt bei dieser Demodulationsschaltung ein erstes Anschlusspaar, das an die ersten und zweiten Anschlüsse 75, 76 des Widerstandsnetzwerkes 70 angeschlossen ist und über welches dem Mischer 54A, 54B das Differenzsignal Vdiff zugeführt ist.

Neben dem ersten Anschlusspaar weist der Mischer 54 ein zweites Anschlusspaar auf, dem ein Summen-Spannungssignal Vsum zugeführt ist, das der phasenverschobenen Summe der ersten und zweiten Sekundärspannung Vs1, Vs2 entspricht. Dieses Summensignal Vsum wird durch zwei Allpassfilter 81A, 81B erzeugt, von denen ein erstes zwischen den ersten und zweiten Anschluss 15, 16 der ersten Sekundärwicklung 12 geschaltet ist und die erste Sekundärspannung Vs1 filtert, und von denen ein zweites zwischen den ersten und zweiten Anschluss 25, 26 der zweiten Sekundärwicklung 22 geschaltet ist und die zweite Sekundärspannung Vs2 filtert. Die beiden Allpassfilter 81A, 81B sind jeweils unter Verwendung zweier Widerstände und Kondensatoren realisiert und weisen jeweils zwei Ausgänge 811A, 811B, 812A, 812B auf. Die Ausgänge der Allpassfilter 81A, 81B sind miteinander verbunden, indem ein erster Ausgang 811A des ersten Allpassfilters 81A an einen ersten Ausgang 811B des zweiten Allpassfilters 81B und ein zweiter Ausgang 812A des ersten Allpassfilters 81A an einen zweiten Ausgang 812B des zweiten Allpassfilters 81B angeschlossen ist. Ohne weitere Beschaltung würde zwischen den Ausgängen 811A, 812A des ersten Allpassfilters 81A eine Spannung Vs1' anliegen, die der um 90° phasenverschobenen ersten Sekundärspannung Vs1 entspricht, und würde zwischen den Ausgängen 811B, 812B des zweiten Allpassfilters 81B eine Spannung Vs2' anliegen, die der um 90° phasenverschobenen zweiten Sekundärspannung Vs2 entspricht.

Die beiden Allpässe 81A, 81B sind jeweils gleich dimensioniert und die Zeitkonstante beträgt R·C = 1/(2Πf) so dass zwischen den gemeinsamen Ausgängen 811, 812 ein Summensignal Vsum anliegt, für das gilt:

$$Vsum = 0,5[Vs1(\omega t + 90°) + Vs1(\omega t + 90°)] \qquad (10).$$

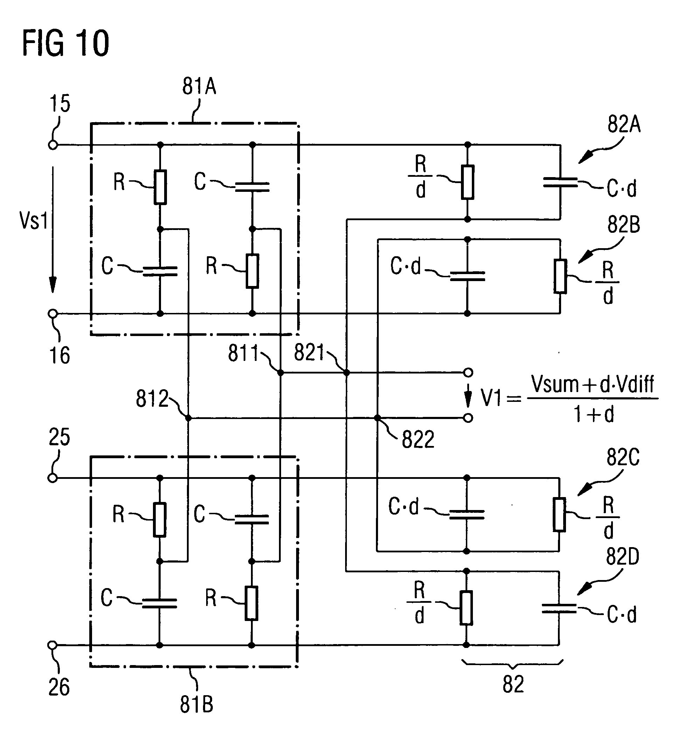

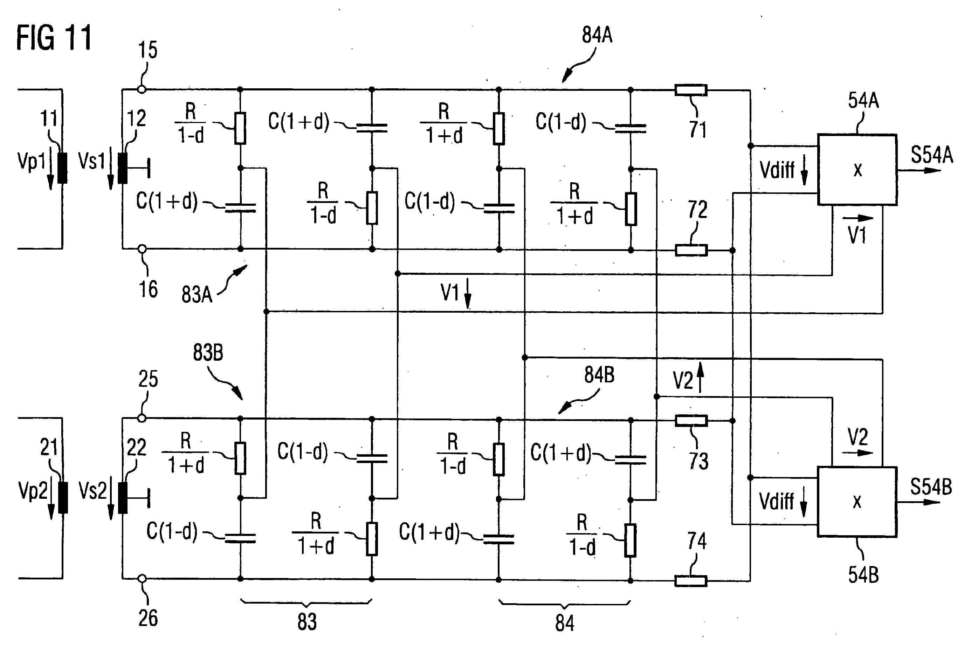

Mittels eines passiven Netzwerkes aus Widerständen und Kondensatoren lassen sich darüber hinaus auch Spannungssignale erzeugen, die sich aus einer Summe der ersten und zweiten Sekundärspannungen Vs1, Vs2 und einer gedämpften Differenz dieser ersten und zweiten Sekundärspannungen zusammensetzen, wie nachfolgend anhand der Figuren 10 und 11 erläutert wird.

Figur 10 zeigt eine Anordnung zur Erzeugung eines Summensignals, das sich aus einer Summe der ersten und zweiten Sekundärspannungen und einer gedämpften Differenz dieser Sekundärspannungen zusammensetzt und

für das gilt:

$$V1 = (Vsum+d \cdot Vdiff)/(1+d), \quad (11)$$

mit Vdiff = (Vs1-Vs2)/2. d bezeichnet einen positiven Gewichtungsfaktor kleiner als 1.

Die dargestellte Schaltungsanordnung umfasst außer den bereits zuvor anhand von Figur 9 erläuterten Allpassfiltern 81A, 81B, die gemeinsame Ausgänge besitzen, ein Widerstandsnetzwerk 82 mit komplexen Widerständen 82A-82D, das zwei Ausgänge 821, 822 aufweist, von denen ein erster Ausgang 821 an den ersten gemeinsamen Ausgang 811 der Allpassfilter 81A, 81B angeschlossen ist und von denen ein zweiter an den zweiten gemeinsamen Ausgang 812 der Allpassfilter 81A, 81B angeschlossen ist. Bei diesem komplexen Widerstandsnetzwerk sind die ersten Anschlüsse 15, 25 der Sekundärwicklungen über jeweils einen der komplexen Widerstände an den ersten Anschluss 821 angeschlossen. Außerdem sind die zweiten Anschlüsse 16, 26 der Sekundärwicklungen über jeweils einen der komplexen Widerstände an den zweiten Anschluss 822 angeschlossen. Die komplexen Widerstände 82A-82D des Widerstandsnetzwerkes 82 sind jeweils gleich dimensioniert und sind jeweils durch eine Parallelschaltung eines ohmschen Widerstandes und eines Kondensators realisiert. Die Widerstandswerte der ohmschen Widerstände betragen hierbei R/d, wobei R der Widerstandswert der gleichen ohmschen Widerstände der Allpassfilter 81A, 81B sind und d ein positiver Dämpfungsfaktor kleiner 1 ist. Die Kapazitätswerte der Kondensatoren der komplexen Widerstände betragen C·d, wobei C der Kapazitätswert der gleichen Kondensatoren der Allpassfilter 81A, 81B und d der positive Dämpfungsfaktor kleiner 1 ist.

Bei dieser auf die Bauelemente der Allpassfilter 81A, 81B abgestimmten Dimensionierung der komplexen Widerstände 82A-82D lässt sich zeigen, dass für die Spannung zwischen den gemeinsamen Anschlüssen der Allpassfilter 81A, 81B und des Widerstandsnetzwerks die oben angegebene Beziehung (11) gilt.

Ein passives Netzwerk der in Figur 10 dargestellte Art eignet sich auch zur Erzeugung eines Ausgangssignals

$$V2= (Vsum-d \cdot Vdiff)/(1+d) \quad (12)$$

aus den Sekundärspannungen Vs1, Vs2. Das in Figur 10 dargestellte Netzwerk ist hierfür so zu modifizieren, dass der zweite Anschluss 822 des Widerstandsnetzwerkes 82 an den ersten gemeinsamen Anschluss 811 der Allpassfilter 81A, 81B und der erste Anschluss 821 des Widerstandsnetzwerks 82 an den zweiten gemeinsamen Anschluss 812 der Allpassfilter 81A, 81B angeschlossen ist.

Das in Figur 10 dargestellte passive Netzwerk mit 16 Bauelementen lässt sich zu einem passiven Netzwerk 83 mit lediglich 8 Bauelementen reduzieren, das in einem Ausführungsbeispiel einer Demodulationsschaltung in Figur 11 dargestellt ist. Die Vereinfachung ergibt sich, wenn parallel geschaltete Bauelemente zu einem Bauelement zusammengefasst werden und wenn Bauelemente, die an gegenphasige Signale angeschlossen sind, durch parallel geschaltete Elemente ersetzt werden, von denen eines negativ ist, wobei diese parallel geschalteten Bauelemente dann wieder zu einem Bauelement zusammengefasst werden.

Das reduzierte Netzwerk 83 umfasst ein erstes Brückenfilter 83A das zwischen die Anschlüsse 15, 16 der ersten Sekundärwicklung 12 geschaltet ist und das jeweils zwei Widerstände und zwei Kondensatoren aufweist. Je ein Widerstand und ein Kondensator sind dabei in Reihe zueinander zwischen die Anschlüsse 15, 16 der ersten Sekundärwicklung geschaltet. Mittenabgriffe dieser Reihenschaltungen bilden hierbei Ausgänge des ersten Brückenfilters. Bezogen auf die Widerstandswerte der Widerstände der Allpassfilter und die Kapazitätswerte der Kondensatoren der Allpassfilter gemäß Figur 9 betragen die Widerstandswerte der Widerstände des ersten Brückenfilters 83A R/(1-d) und die Kapazitätswerte der Kondensatoren beragen C·(1+d).

Das reduzierte Netzwerk 83 umfasst außerdem ein zweites Brückenfilter 83B, das zwischen die Anschlüsse 25, 26 der zweiten Sekundärwicklung 22 geschaltet ist und das entsprechend des ersten Brückenfilters 83A aufgebaut ist. Für die Widerstandswerte der Widerstände dieses zweiten Brückenfilters 83B gilt hierbei R/(1+d), während für die Kapazitätswerte der Kondensatoren c(1-d) gilt. Die Ausgänge der ersten zweiten Brückenfilter 83A, 83B sind miteinander verbunden, indem ein erster Ausgang des ersten Brückenfilters 83A an einen ersten Ausgang des zweiten Brückenfilters 83B und ein zweiter Ausgang des ersten Brückenfilters 83A an einen zweiten Ausgang des zweiten Brückenfilters 83B angeschlossen ist. Zwischen den gemeinsamen Ausgängen dieser beiden Brückenfilter 83A, 83B steht das erste Ausgangssignal V1 zur Verfügung, das zwei Signalanteile umfasst, einen ersten positiven Signalanteil, der abhängig ist von der Summe der phasenverschobenen Sekundärspannungen Vs1, Vs2, und einen zweiten positiven Signalanteil, der abhängig ist von der Differenz der Sekundärspannungen Vs1, Vs2.

Modifiziert man das in Figur 10 dargestellte Netzwerk dahingehend, dass das Ausgangssignal V2 erzeugt wird und reduziert man das modifizierte Netzwerk, so ergibt sich ein zweites reduziertes Netzwerk 84, das in Figur 11 dargestellt ist. Dieses reduzierte Netzwerk weist zwei Brückenfilter 84A, 84B auf, von denen ein erstes zwischen die Anschlüsse 15, 16 der ersten Sekundärwicklung 12 geschaltet ist und von denen ein zweites zwischen die Anschlüsse 25, 26 der zweiten Sekundärwicklung 22 geschaltet ist. Die Ausgangspaare der beiden Brückenfilter 84A, 84B sind miteinander verbunden. Zwischen den gemeinsamen Ausgängen der beiden Brückenfilter 84A, 84B steht hierbei das zweite Ausgangssignal V2 zur Verfügung, das zwei Signalanteile umfasst, einen ersten positiven Signalanteil, der abhängig ist von der Summe der phasenverschobenen Sekundärspannungen Vs1, Vs2, und einen zweiten negativen Signalanteil, der abhängig ist von der Differenz der Sekundärspannungen Vs1, Vs2.

Die in Figur 11 dargestellte Demodulationsschaltung weist entsprechend der Demodulationsschaltung gemäß Figur 7 zwei Mischer 54A, 54B auf. Einem ersten 54A der Mischer ist hierbei das Differenzsignal Vdiff und das erste Ausgangssignal V1 des ersten reduzierten Netzwerks 83 zugeführt, und einem zweiten 54B der Mischer ist hierbei das Differenzsignal Vdiff und das zweite Ausgangssignal V2 des zweiten reduzierten Netzwerks 84 zugeführt. Ausgangssignale S54A, S54B dieser Mischer werden in bereits erläuterter Weise weiter verarbeitet.

Mittels des zuvor erläuterten Signalübertragers lassen sich in erläuterter Weise drei voneinander unterscheidbare Sendesymbole a, b, c übertragen.

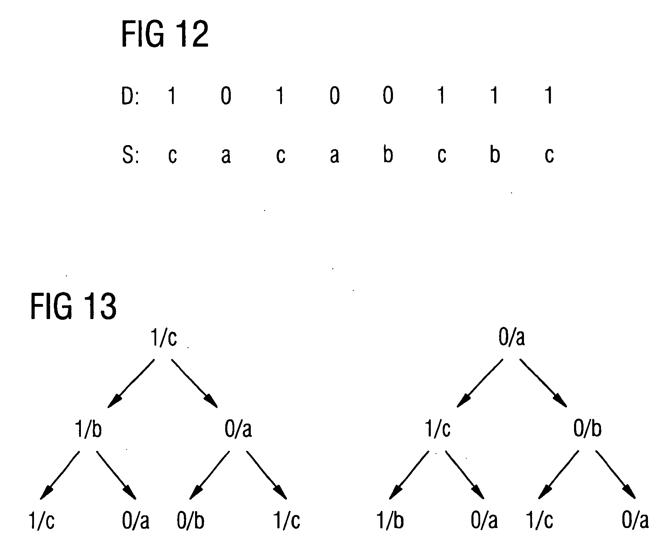

Ein mögliches Übertragungsverfahren für einen solchen Signalübertrager wird nachfolgend anhand von Figur 12 erläutert. Figur 12 zeigt eine zweiwertige zu übertragende Datenfolge D und die aus dieser Datenfolge resultierende Folge S von übertragenen Sendesymbolen a, b, c. Die Umsetzung der Datenfolge D auf die Sendesymbolfolge S wird nachfolgend als Kodierung bezeichnet. Diese Kodierung erfolgt in dem dargestellten Beispiel derart, dass die Sendesymbolfolge S keine zwei gleichen aufeinanderfolgende Sendesymbole a, b, c umfasst. Auf diese Weise ist eine selbstsynchronisierende Datenübertragung möglich, d. h. zusammen mit dem Datensignal ist kein zusätzliches Taktsignal zu übertragen, da für jedes Datensymbol der Datensymbolfolge D ein eigenes Sendesymbol, das sich von dem vorangehenden Sendesymbol unterscheidet, übertragen wird. Die Kodierung der Datensymbolfolge D auf die Sendesymbolfolge S erfolgt derart, dass für ein erstes Datensymbol, in dem Beispiel das Datensymbol "1", ein erstes der drei Sendesymbole, in dem Beispiel das Sendesymbol a übertragen wird. Für ein zweites Datensymbol, in dem Beispiel "0", wird ein zweites der drei Sendesymbole, in dem Beispiel das Sendesymbol c, übertragen. Das dritte der drei Sendesymbole, in dem Beispiel das Sendesymbol b, wird übertragen, um eine wiederholte Übertragung eines der ersten und zweiten Datensignale anzuzeigen. Für eine Datenfolge 1 1 1 1 1 ... mit mehreren aufeinanderfolgenden ersten Datensignalen ergibt sich somit eine Sendesymbolfolge a b a b a b ..., während sich für eine Datensignalfolge 0 0 0 0 0 0 ... mit mehreren aufeinanderfolgenden zweiten Datensignalen eine Sendesymbolfolge c b c b c b ... ergibt.

Dieses zuvor erläuterte Kodierungsschema ist in Figur 13 nochmals veranschaulicht. Figur 13 zeigt im linken Teil eine Kodierung einer mit dem ersten Datensymbol 1 beginnenden Datenfolge und im rechten Teil eine Kodierung einer mit einem zweiten Datensymbol 0 beginnenden Datenfolge. Neben den Datensymbolen sind jeweils die übertragenen Sendesymbole dargestellt. Die dargestellten Kodierschemata zeigen jeweils die Kodierung von drei aufeinanderfolgenden Datensymbolen. Bei dieser Kodierung ist die Abbildung eines Datensymbols auf ein Sendesymbol von dem vorangehenden Datensymbol abhängig. Ein Datensymbol und das zugehörige Sendesymbol des in Figur 13 dargestellten Kodierschemas bilden jeweils einen Zustand des Kodierschemas, die Zustände 1/c und 0/a bilden dabei Anfangszustände dieser Kodierung. Die Kodierschemata wiederholen sich dabei jeweils dann, wenn einer dieser Anfangszustände innerhalb des Kodierschemas erreicht wird.

Pausen in der Signalübertragung, also Zeitperioden, während derer keine Datensymbole zu übertragen sind und während derer entsprechend keine Sendesymbole übertragen werden, können Bezug nehmend auf die Erläuterung zu den Figuren 4 und 5 durch Auswertung der Amplitude des Differenzsignals ermittelt werden. Die Amplitude dieses Differenzsignals ist jeweils dann Null oder liegt unterhalb einem vorgegebenen Signalpegel, wenn keine Sendesymbole übertragen werden.

Bei einer störungsfreien Übertragung entspricht die am Ausgang des Demodulators 50 anliegende Empfangssymbolfolge der Sendesymbolfolge. Aus dieser Sendesymbolfolge kann in Kenntnis des senderseitig angewendeten Kodierschemas auf einfache Weise die gesendete Datenfolge rekonstruiert werden. Der Empfang des dritten Empfangssymbols c' steht hierbei für ein erstes gesendetes Datensymbol, der Empfang des ersten Empfangssymbols a' steht für ein zweites gesendetes Datensymbol, und der Empfang des zweiten Empfangssymbols b' steht für das gleiche Datensymbol wie das unmittelbar zuvor empfangene.

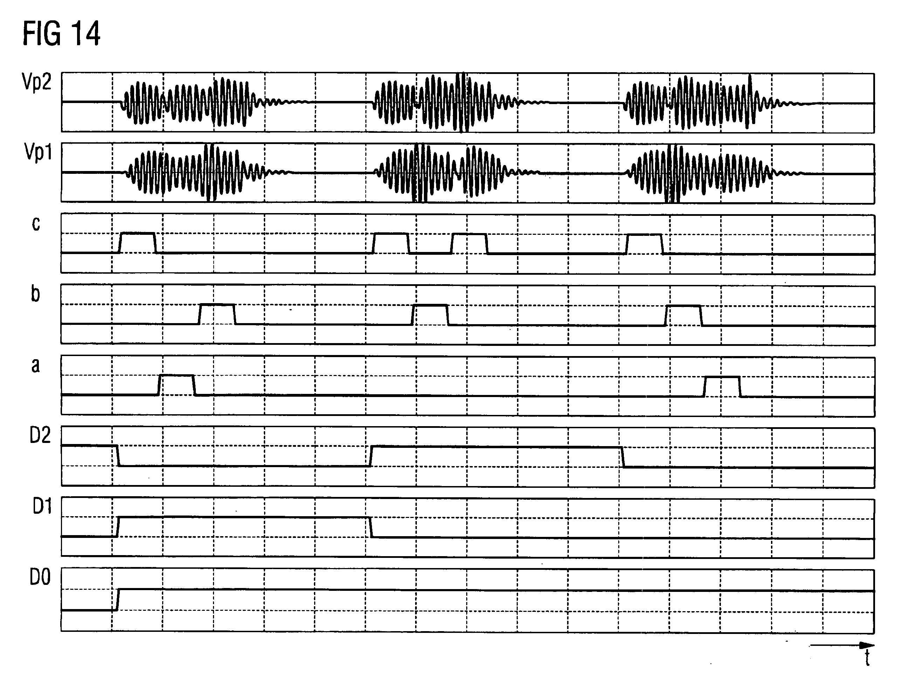

Ein weiteres Übertragungsverfahren unter Verwendung des zuvor erläuterten Signalübertragers wird nachfolgend anhand von Figur 14 erläutert. Gegenstand dieses Signalübertragungsverfahrens ist die Übertragung von drei jeweils zweiwertigen Datenfolgen D0, D1, D2. Bei diesem Signalübertragungsverfahren werden in bestimmten Zeitabständen Sendesymbolfolgen mit drei Sendesymbolen übertragen. Diese drei aufeinanderfolgend übertragenen Sendesymbole repräsentieren dabei die jeweiligen Signalpegel der Datenfolgen D0, D1, D2. Bei dem in Figur 14 dargestellten Beispiel repräsentiert das zuerst übertragene Sendesymbol den Signalpegel der ersten Datenfolge D0, das zweite übertragene Sendesymbol repräsentiert den Datenwert der zweiten Datenfolge D1 und das dritte übertragene Sendesymbol repräsentiert den Datenwert der dritten Datenfolge D2. Ein High-Pegel der jeweiligen Datenfolge wird hierbei durch ein erstes Sendesymbol, in dem Beispiel das Sendesymbol c übertragen, während ein Low-Pegel der jeweiligen Datenfolge in Form eines zweiten Sendesymbols, in dem Beispiel in Form des Sendesymbols a, übertragen wird. Die Kodierung erfolgt derart, dass keine zwei gleichen Sendesymbole unmittelbar aufeinanderfolgend übertragen werden. Dies wird dadurch erreicht, dass anstelle einer wiederholten Übertragung des ersten oder dritten Sendesymbols a, c das zweite Sendesymbol b übertragen wird.

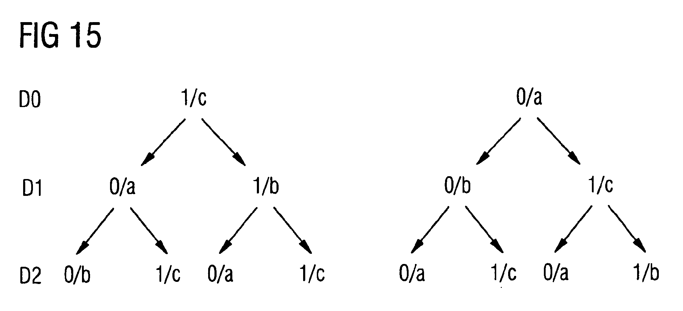

Figur 15 zeigt das dem anhand von Figur 14 erläuterten Übertragungsverfahren zugrunde liegende Kodierschema. Eine "1" steht in Figur 15 für einen High-Pegel der jeweiligen Datenfolge, während eine "0" für einen Low-Pegel der jeweiligen Datenfolge D0-D2 steht. Neben den jeweiligen Werten der Datenfolge sind in Figur 15 die übertragenen Sendesymbole wiedergegeben.

Zum besseren Verständnis des erfindungsgemäßen Übertragungsverfahrens sind in Figur 14 neben den Datenfolgen D0-D2 und den übertragenen Sendesymbolen a-c auch die Primärspannungen Vp1, Vp2 des Signalübertragers dargestellt.

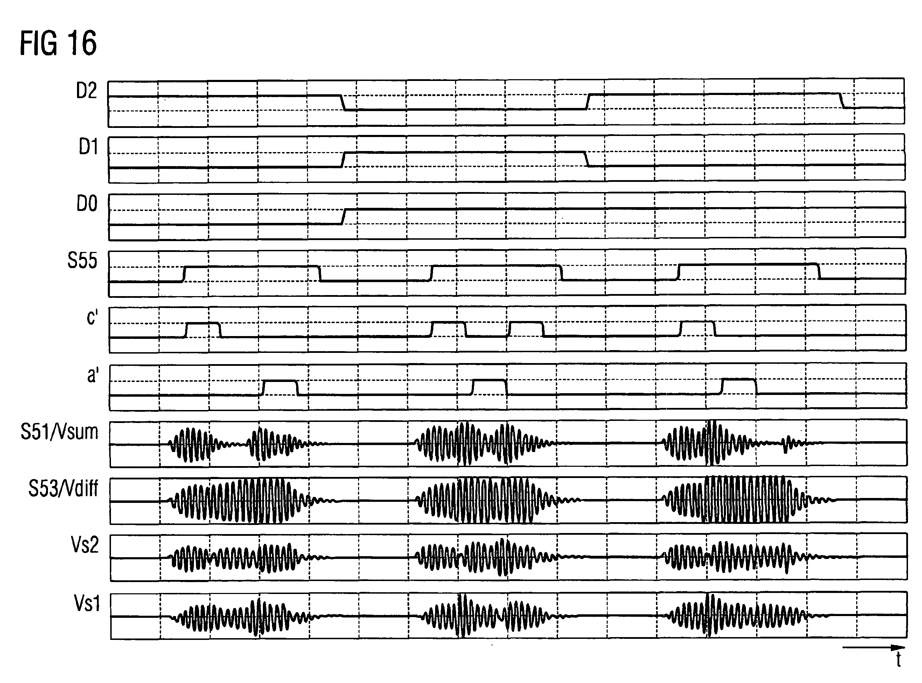

Figur 16 zeigt für das zuvor erläuterte Datenübertragungsverfahren beispielhaft zeitliche Verläufe der Datenfolgen D0, D1, D2, der sekundärseitig an dem Signalübertrager abgreifbaren Spannungen Vs1, Vs2, des Differenzsignals (S53 in den Figuren 6 und 7 bzw. Vdiff in Figur 9), des Summensignals , sowie der Demodulationssignale a', c'. Diese Demodulationssignale a', c' entsprechen bei einer störungsfreien Übertragung den übertragenen Sendesymbolen a, c. Dargestellt ist in Figur 16 außerdem das Ausgangssignal der Amplitudenauswerteeinheit (55 in Figur 6), die die Amplitude des Differenzsignals auswertet. Pausen der Signalübertragung liegen in ersichtlicher Weise dann vor, wenn die Amplitude dieses Differenzsignals bzw. des Auswertesignals S55 Null ist.

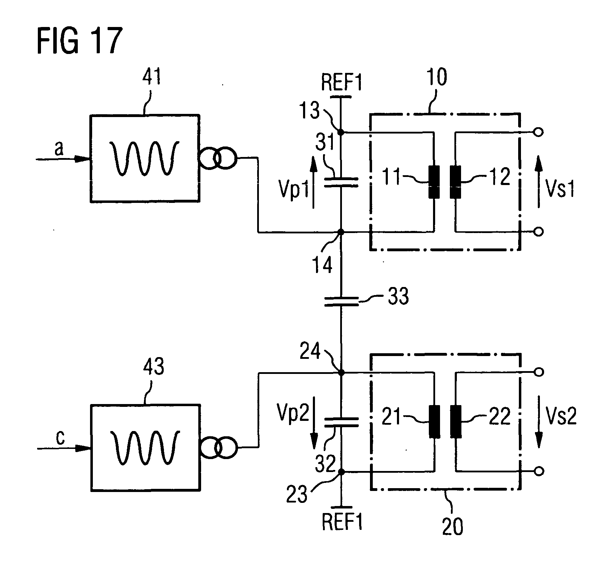

Figur 17 zeigt eine Abwandlung der in Figur 1 dargestellten Signalübertragungsvorrichtung. Bei der Signalübertragungsvorrichtung sind lediglich zwei Anregungsschaltungen 41, 43 vorhanden, so dass zwei unterschiedliche Phasenbeziehungen der Parallelschwingkreise 1, 2 für eine Datenübertragung einstellbar sind, in dem dargestellten Beispiel sind Phasenverschiebungen von +90° und -90° einstellbar.

Die Anregung der Schwingkreise 1, 2 erfolgt bei den bisher erläuterten Signalübertragern vorzugsweise derart, dass keine gleichphasigen Schwingungen in den beiden Schwingkreisen entstehen. Solche gleichphasigen Schwingungen können beispielsweise durch Störsignale angeregt werden, die in gleicher Weise auf die Schwingkreise wirken. Durch die Nicht-Nutzung gleichphasiger Signale zur Datenübertragung ist es möglich, Nutzsignale sicher von Störsignalen zu unterscheiden. Bei den zuvor erläuterten Demodulationsschaltungen 50 würden gleichphasige Signale zu einem Differenzsignal gleich Null führen, so dass die Ausgangssignale der Mischer ebenfalls gleich Null sind. Die Störsignale werden dadurch sicher ausgefiltert.

Für die bisherige Erläuterung wurde davon ausgegangen, dass die beiden Schwingkreise 1, 2 zur Signalübertragung derart angeregt werden, dass sich Phasenverschiebungen der Schwingungen von 90°, 180° und 270° (Figur 1) oder 90° und 270° (Figur 17) einstellen. Selbstverständlich sind beliebige weitere Anregungsarten anwendbar, bei denen die Schwingkreise zu Schwingungen mit unterschiedlicher Phasenlage angeregt werden. Es besteht insbesondere die Möglichkeit mehr als drei unterschiedliche Phasenlagen einzustellen, beispielsweise 90°, 135°, 180°, 225° und 270°, um fünf unterschiedliche Sendesymbole übertragen zu können.

**Patentansprüche**

1. Signalübertragungsvorrichtung für die Übertragung von wenigstens zwei unterschiedlichen Sendesymbolen (a, b, c), die aufweist:

   einen ersten Übertrager (10) mit einer Primärwicklung (11) und einer Sekundärwicklung (12), die induktiv miteinander gekoppelt sind, und einen zweiten Übertrager (20) mit einer Primärwicklung (21) und einer Sekundärwicklung (22), die induktiv miteinander gekoppelt sind,
   einen ersten Schwingkreis (1) mit der Primärwicklung (11) oder der Sekundärwicklung (12) des ersten Übertragers (10) als Schwingkreisinduktivität (11; 12) und mit einer ersten Schwingkreiskapazität (31), und einen zweiten Schwingkreis (2) mit der Primärwicklung (21) oder der Sekundärwicklung (22) des zweiten Übertragers (20) als Schwingkreisinduktivität (21; 22) und mit einer zweiten Schwingkreiskapazität (32),
   ein Kopplungselement (33), das den ersten Schwingkreis (1) an den zweiten Schwingkreis (2) koppelt,
   eine erste Anregungsschaltung (41), die an den ersten Schwingkreis (1) gekoppelt ist, und wenigstens eine weitere Anregungsschaltung (42, 43), die an den zweiten Schwingkreis (2) gekoppelt ist,
   wobei die erste Anregungsschaltung (41) und die wenigstens eine weitere Anregungsschaltung (42, 43) jeweils dazu ausgebildet sind, in einem aktivierten Zustand, jeweils abhängig von einem der wenigstens zwei unterschiedlichen Sendesymbolen (a, b, c), den ersten Schwingkreis und den zweiten Schwingkreis zu Schwingungen anzuregen, die um eine Phasenverschiebung ungleich Null gegeneinander phasenverschoben sind, wobei diese Phasenverschiebungen für die erste Anregungsschaltung (41) und die wenigstens eine weitere Anregungsschaltung (42, 43) unterschiedlich sind.

2. Signalübertragungsvorrichtung nach Anspruch 1, die eine zweite Anregungsschaltung (42) aufweist, die an den ersten und zweiten Schwingkreis (1, 2) gekoppelt ist und die eine dritte Anregungsschaltung (43) aufweist, die an den zweiten Schwingkreis (2) gekoppelt ist.

3. Signalübertragungsvorrichtung nach Anspruch 2, bei der die zweite Anregungsschaltung (42) dazu ausgebildet ist, den ersten und zweiten Schwingkreis (1, 2) zu gegenphasigen Schwingungen anzuregen.

4. Signalübertragungsvorrichtung nach einem der vorangehenden Ansprüche, bei der
die Primärwicklung (11) des ersten Übertragers die Schwingkreisinduktivität des ersten Schwingkreises (1) bildet,
die Primärwicklung (21) des zweiten Übertragers (20) die Schwingkreisinduktivität des zweiten Schwingkreises (2) bildet.

5. Signalübertragungsvorrichtung nach Anspruch 4, bei dem die erste Anregungsschaltung (41) direkt an den ersten Schwingkreis (1) angeschlossen ist und die weitere Anregungsschaltung (43) direkt an den zweiten Schwingkreis (2) angeschlossen ist.

6. Signalübertragungsvorrichtung nach Anspruch 4,
die eine erste Anregungswicklung (17) aufweist, die induktiv mit der Primärwicklung (11) des ersten Schwingkreises (1) gekoppelt ist und an die die erste Anregungsschaltung (41) angeschlossen ist, und
die eine zweite Anregungswicklung (27) aufweist, die induktiv mit der Primärwicklung (21) des zweiten Schwingkreises (2) gekoppelt ist und an die die weitere Anregungsschaltung (43) angeschlossen ist.

7. Signalübertragungsvorrichtung nach einem der Ansprüche 1 bis 3, bei der
die Sekundärwicklung (12) des ersten Übertragers die Schwingkreisinduktivität des ersten Schwingkreises (1) bildet,
die Sekundärwicklung (22) des zweiten Übertragers (20) die Schwingkreisinduktivität des zweiten Schwingkreises (2) bildet.

8. Signalübertragungsvorrichtung nach Anspruch 7, bei dem die erste Anregungsschaltung (41) an die Primärwicklung (11) des ersten Übertragers (10) angeschlossen ist und die weitere Anregungsschaltung (43) an die Primärwicklung (21) des zweiten Übertragers (20) angeschlossen ist.

9. Signalübertragungsvorrichtung nach einem der vorangehenden Ansprüche, bei dem die Schwingkreise direkt miteinander gekoppelt sind, indem das Kopplungselement (33) zwischen die Schwingkreisinduktivitäten geschaltet ist.

10. Signalübertragungsvorrichtung nach einem der Ansprüche 1 bis 8, bei dem die Schwingkreise indirekt miteinander gekoppelt sind, indem das Kopplungselement (33) zwischen die Wicklungen des ersten und zweiten Übertragers (10, 20) geschaltet sind, die nicht die Schwingkreisinduktivität bilden.

11. Signalübertragungsvorrichtung nach einem der vorangehenden Ansprüche, bei der das Kopplungselement (33) ein kapazitives oder induktives Kopplungselement ist.

12. Signalübertragungsvorrichtung nach einem der vorangehenden Ansprüche bei der der erste und zweite Schwingkreis (1, 2) Parallelschwingkreise sind.

13. Signalübertragungsvorrichtung nach einem der vorangehenden Ansprüche, bei der die erste Anregungsschaltung (41) dazu ausgebildet ist, nach Maßgabe eines der Anregungsschaltung (41) zugeführten ersten Steuersignals (S1) einen von einer Spannung über dem ersten Schwingkreis (1) abhängigen Anregungsstrom in den ersten Schwingkreis (1) einzuspeisen.

14. Signalübertragungsvorrichtung nach Anspruch 13 bei der der Anregungsstrom abhängig von der Spannung über dem ersten Schwingkreis einen ersten Signalpegel oder einen zweiten Signalpegel annimmt.

15. Signalübertragungsvorrichtung nach Anspruch 2 , bei der die dritte Anregungsschaltung (43) dazu ausgebildet ist, nach Maßgabe eines der Anregungsschaltung (43) zugeführten dritten Steuersignals (S3) einen von einer Spannung über dem zweiten Schwingkreis (2) abhängigen Anregungsstrom in den zweiten Schwingkreis (2) einzuspeisen.

16. Signalübertragungsvorrichtung nach Anspruch 15 bei der der Anregungsstrom abhängig von der Spannung über dem zweiten Schwingkreis einen ersten Signalpegel oder einen zweiten Signalpegel annimmt.

17. Signalübertragungsvorrichtung nach Anspruch 2 , bei der die zweite Anregungsschaltung (42) dazu ausgebildet ist, nach Maßgabe eines der Anregungsschaltung (43) zugeführten zweiten Steuersignals (42) einen ersten Anregungsstrom (142_1) in den ersten Schwingkreis (1) einzuspeisen und einen zu dem ersten Strom (I42_1) phasenverschobenen zweiten Strom (I42_2) in den zweiten Schwingkreis (2) einzuspeisen.

18. Signalübertragungsvorrichtung nach Anspruch 17, bei der die ersten und zweiten Anregungsströme gegenphasige Ströme sind.

19. Signalübertragungsvorrichtung nach einem der vorangehenden Ansprüche, die eine Demodulationsschaltung (50) aufweist, die an die Sekundärwicklungen (12, 22) der ersten und zweiten Übertrager (10, 20) angeschlossen ist und die aufweist:

   eine Differenzbildungseinheit (53), die an die erste und zweite Sekundärwicklung (12, 22) gekoppelt ist und die ein Differenzsignal (S53) erzeugt,
   eine Summenbildungseinheit (51), die an die erste und zweite Sekundärwicklung (12, 22) gekoppelt ist und die ein Summensignal (S51) erzeugt,
   eine Phasenverschiebungseinheit (52), der das Summensignal (S51) zugeführt ist und die ein phasenverschobenes Summensignal (S52) bereitstellt,
   wenigstens einen Mischer (54), dem das Differenzsignal (S53) und ein von dem phasenverschobenen Summensignal (S52) abhängiges Signal zugeführt sind und der ein Mischerausgangssignal (S54) bereitstellt,
   eine Auswerteeinheit (55-58), der das Mischerausgangssignal (S54) zugeführt ist und die wenigstens ein Demodulationssignal (S1', S2', S3') abhängig von einem Vergleich des Mischerausgangssignals mit wenigstens einem Schwellenwert erzeugt.

20. Signalübertragungsvorrichtung nach Anspruch 19, bei der die Auswerteeinheit (55-58) aufweist:

   einen ersten Schwellenwertdetektor (56), der das Mischerausgangssignal (S54) mit einem ersten Schwellenwert vergleicht und der ein erstes Demodulationssignal (S1') bereitstellt,
   einen zweiten Schwellenwertdetektor (57), der das Mischerausgangssignal (S54) mit einem zweiten Schwellenwert vergleicht und der ein zweites Demodulationssignal (S3') bereitstellt.

21. Signalübertragungsvorrichtung nach Anspruch 20, bei der der Auswerteeinheit (55-58) das Differenzsignal (S53) zugeführt ist und bei der die Auswerteeinheit (55-58) dazu ausgebildet ist, ein drittes Demodulationssignal (S2') abhängig von dem Differenzsignal (S53) und dem ersten und zweiten Demodulationssignal (S1', S2') zu erzeugen.

22. Signalübertragungsvorrichtung nach Anspruch 19, bei der die Demodulationsschaltung (50) folgende weitere Merkmale aufweist:

   einen ersten Mischer (54A) und einen dem ersten Mischer nachgeschalteten ersten Schwellenwertdetektor (55A), wobei dem ersten Mischer ein von dem phasenverschobenen Summensignal (S52) und von dem Differenzsignal (S53) abhängiges Signal zugeführt ist und an einem Ausgang des ersten Schwellenwertdetektors (55A) ein erstes Demodulationssignal (S1') zur Verfügung steht,
   einen zweiten Mischer (54B) und einen dem zweiten Mischer (54B) nachgeschalteten zweiten Schwellenwertdetektor (55B), wobei dem zweiten Mischer (54B) ein von dem phasenverschobenen Summensignal (S52) und von dem Differenzsignal (S53) abhängiges Signal zugeführt ist und an einem Ausgang des zweiten Schwellenwertdetektors (55B) ein zweites Demodulationssignal (S3') zur Verfügung steht.

23. Signalübertragungsverfahren für die Übertragung von wenigstens zwei unterschiedlichen Sendesymbolen (a, b, c) mit den Verfahrenschritten:

   Anregung eines ersten Schwingkreises (1) und eines zweiten Schwingkreises (2), durch eine erste Anregungsschaltung (41) und wenigstens eine weitere Anregungsschaltung (42, 43), wobei die erste Anregungsschaltung (41) und die wenigstens eine weitere Anregungsschaltung (42, 43), in einem aktivierten Zustand, jeweils abhängig von einem der wenigstens zwei unterschiedlichen Sendesymbolen (a, b, c), den ersten Schwingkreis (1) und den zweiten Schwingkreis (2) zu Schwingungen anregen, die um eine Phasenverschiebung ungleich Null gegeneinander phasenverschoben sind, wobei die Phasenverschiebung für jedes der wenigstens zwei unterschiedlichen Sendesymbole unterschiedlich ist, worin:

ein erster Übertrager (10) eine Primärwicklung (11) und eine Sekundärwicklung (12) aufweist, die induktiv miteinander gekoppelt sind, und ein zweiter Übertrager (20) eine Primärwicklung (21) und eine Sekundärwicklung (22) aufweist, die induktiv miteinander gekoppelt sind, der erste Schwingkreis (1) die Primärwicklung (11) oder die Sekundärwicklung (12) des ersten Übertragers (10) als Schwingkreisinduktivität (11; 12) und eine erste Schwingkreiskapazität (31) aufweist, und der zweite Schwingkreis (2) die Primärwicklung (21) oder die Sekundärwicklung (22) des zweiten Übertragers (20) als Schwingkreisinduktivität (21; 22) und eine zweite Schwingkreiskapazität (32) aufweist, ein Kopplungselement (33) den ersten Schwingkreis (1) an den zweiten Schwingkreis (2) koppelt,

Auswertung einer Phasenbeziehung zwischen den von den Sekundärwicklungen (12, 22) der Übertrager abgegriffenen Signalen (Vs1, Vs2).

24. Signalübertragungsverfahren nach Anspruch 13, das für die Übertragung einer zweiwertigen Datenfolge (D) mit ersten und zweiten Datensymbolen die Verfahrensschritte aufweist:

Übertragen eines ersten Sendesymbols (c) für ein erstes Datensymbol der Datenfolge (D),
Übertragen eines zweiten Sendesymbols (a) für ein zweites Datensymbol der Datenfolge (D),
abwechselndes Übertragen des ersten Sendesymbols (c) und eines dritten Sendesymbols (b) für wenigstens zwei aufeinanderfolgende erste Datensymbole der Datenfolge (D), und
abwechselndes Übertragen des zweiten Sendesymbols (a) und des dritten Sendesymbols (b) für wenigstens zwei aufeinanderfolgende zweite Datensymbole der Datenfolge (D).

25. Signalübertragungsverfahren nach Anspruch 23, bei dem für eine Übertragung von n, mit n≥2, jeweils zweiwertigen, einen ersten oder zweiten Datenwert annehmenden Datenfolgen (D0, D1, D3) eine Sendesymbolfolge mit n aufeinanderfolgenden Sendesymbolen, von denen jedes Sendesymbol den Datenwert einer Datenfolge (D0, D1, D2) repräsentiert, übertragen wird.

**Claims**

1. Signal transmitting device for transmitting at least two different transmit symbols (a, b, c) exhibiting the following:

a first transformer (10) with a primary winding (11) and a secondary winding (12) which are inductively coupled to one another and a second transformer (20) with a primary winding (21) and a secondary winding (22) which are inductively coupled to one another,
a first resonant circuit (1) with the primary winding (11) or the secondary winding (12) of the first transformer (10) as resonant circuit inductance (11; 12) and with a first resonant circuit capacitance (31), and a second resonant circuit (2) with the primary winding (21) or the secondary winding (22) of the second transformer (20) as resonant circuit inductance (21; 22) and with a second resonant circuit capacitance (32),
a coupling element (33) which couples the first resonant circuit (1) to the second resonant circuit (2),
a first excitation circuit (41), which is coupled to the first resonant circuit (1), and at least one further excitation circuit (42, 43) which is coupled to the second resonant circuit (2),
the first excitation circuit (41) and the at least one further excitation circuit (42, 43) each being designed to excite the first resonant circuit and the second resonant circuit into oscillations in an activated state, in each case on the basis of one of the at least two different transmit symbols (a, b, c), which oscillations are phase-shifted with respect to one another by a phase shift which is not equal to zero, these phase shifts being different for the first excitation circuit (41) and the at least one further excitation circuit (42, 43).

2. Signal transmitting device according to Claim 1, which exhibits a second excitation circuit (42) which is coupled to the first and second resonant circuit (1, 2) and which exhibits a third excitation circuit (43) which is coupled to the second resonant circuit (2).

3. Signal transmitting device according to Claim 2, in which the second excitation circuit (42) is constructed for exciting the first and second resonant circuit (1, 2) into antiphase oscillations.

4. Signal transmitting device according to one of the preceding claims, in which:

   the primary winding (11) of the first transformer forms the resonant circuit inductance of the first resonant circuit (1),
   the primary winding (21) of the second transformer (20) forms the resonant circuit inductance of the second resonant circuit (2).

5. Signal transmitting device according to Claim 4, in which the first excitation circuit (41) is connected directly to the first resonant circuit (1) and the further excitation circuit (43) is connected directly to the second resonant circuit (2).

6. Signal transmitting device according to Claim 4,
   which exhibits a first excitation winding (17) which is inductively coupled to the primary winding (11) of the first resonant circuit (1) and to which the first excitation circuit (41) is connected, and
   which exhibits a second excitation winding (27) which is inductively coupled to the primary winding (21) of the second resonant circuit (2) and to which the further excitation circuit (43) is connected.

7. Signal transmitting device according to one of Claims 1 to 3, in which:

   the secondary winding (12) of the first transformer forms the resonant circuit inductance of the first resonant circuit (1),
   the secondary winding (22) of the second transformer (20) forms the resonant circuit inductance of the second resonant circuit (2).

8. Signal transmitting device according to Claim 7, in which the first excitation circuit (41) is connected to the primary winding (11) of the first transformer (10) and the further excitation circuit (43) is connected to the primary winding (21) of the second transformer (20).

9. Signal transmitting device according to one of the preceding claims, in which the resonant circuits are coupled directly to one another in that the coupling element (33) is connected between the resonant circuit inductances.

10. Signal transmitting device according to one of Claims 1 to 8, in which the resonant circuits are coupled indirectly to one another in that the coupling element (33) is connected between the windings of the first and second transformer (10, 20), which windings do not form the resonant circuit inductance.

11. Signal transmitting device according to one of the preceding claims, in which the coupling element (33) is a capacitive or inductive coupling element.

12. Signal transmitting device according to one of the preceding claims, in which the first and second resonant circuit (1, 2) are parallel resonant circuits.

13. Signal transmitting device according to one of the preceding claims, in which the first excitation circuit (41) is arranged for feeding an excitation current, which depends on a voltage across the first resonant circuit (1), into the first resonant circuit (1) as determined by a first control signal (S1) supplied to the excitation circuit (41).

14. Signal transmitting device according to Claim 13, in which the excitation current assumes a first signal level or a second signal level in dependence on the voltage across the first resonant circuit.

15. Signal transmitting device according to Claim 2, in which the third excitation circuit (43) is arranged for feeding an excitation current, which is dependent on a voltage across the second resonant circuit (2), into the second resonant circuit (2) as determined by a third control signal (S3) supplied to the excitation circuit (43).

16. Signal transmitting device according to Claim 15, in which the excitation current assumes a first signal level or a second signal level in dependence on the voltage across the second resonant circuit.

17. Signal transmitting device according to Claim 2, in which the second excitation circuit (42) is arranged for feeding a first excitation current (I42_1) into the first resonant circuit (1) as determined by a second control signal (42) supplied to the excitation circuit (43) and for feeding a second current (I42_2), which is phase-shifted with respect to the first current (I42_1), into the second resonant circuit (2).

**18.** Signal transmitting device according to Claim 17, in which the first and second excitation currents are antiphase currents.

**19.** Signal transmitting device according to one of the preceding claims, which exhibits a demodulation circuit (50) which is connected to the secondary windings (12, 22) of the first and second transformers (10, 20) and which exhibits the following:

a differentiating unit (53) which is coupled to the first and second secondary winding (12, 22), and which generates a difference signal (S53),

a summation unit (51) which is coupled to the first and second secondary winding (12, 22) and which generates a sum signal (S51),

a phase-shifting unit (52) which is supplied with the sum signal (S51) and which provides a phase-shifted sum signal (S52),

at least one mixer (54) which is supplied with the difference signal (S53) and a signal dependent on the phase-shifted sum signal (S52) and which provides a mixer output signal (S54),

an evaluating unit (55-58) which is supplied with the mixer output signal (S54) and which generates at least one demodulation signal (S1', S2', S3') in dependence on a comparison of the mixer output signal with at least one threshold value.

**20.** Signal transmitting device according to Claim 19, in which the evaluating unit (55-58) exhibits the following:

a first threshold detector (56) which compares the mixer output signal (S54) with a first threshold value and which provides a first demodulation signal (S1'),

a second threshold detector (57) which compares the mixer output signal (S54) with a second threshold value and which provides a second demodulation signal (S3').

**21.** Signal transmitting device according to Claim 20, in which the evaluating unit (55-58) is supplied with the difference signal (S53) and in which the evaluating unit (55-58) is arranged for generating a third demodulation signal (S2') in dependence on the difference signal (S53) and the first and second demodulation signal (S1', S2').

**22.** Signal transmitting device according to Claim 19, in which the demodulation circuit (50) exhibits the following further features:

a first mixer (54A) and a first threshold detector (55A) following the first mixer, the first mixer being supplied with a signal dependent on the phase-shifted sum signal (S52) and on the difference signal (S53), and a first demodulation signal (S1') being available at an output of the first threshold detector (55A),

a second mixer (54B) and a second threshold detector (55B) following the second mixer (54B), the second mixer (54B) being supplied with a signal dependent on the phase-shifted sum signal (S52) and on the difference signal (S53), and a second demodulation signal (S3') being available at an output of the second threshold detector (55B).

**23.** Signal transmitting method for transmitting at least two different transmit symbols (a, b, c) comprising the following method steps:

exciting a first resonant circuit (1) and a second resonant circuit (2) by means of a first excitation circuit (41) and at least one further excitation circuit (42, 43), the first excitation circuit (41) and the at least one further excitation circuit (42, 43) exciting the first resonant circuit (1) and the second resonant circuit (2) into oscillations in an activated state, in each case on the basis of one of the at least two different transmit symbols (a, b, c), which oscillations are phase-shifted with respect to one another by a phase shift which is not equal to zero, the phase shift being different for each of the at least two different transmit symbols, wherein:

a first transformer (10) has a primary winding (11) and a secondary winding (12) which are inductively coupled to one another, and a second transformer (20) has a primary winding (21) and a secondary winding (22) which are inductively coupled to one another,

the first resonant circuit (1) has the primary winding (11) or the secondary winding (12) of the first transformer (10) as resonant circuit inductance (11; 12) and has a first resonant circuit capacitance (31), and the second resonant circuit (2) has the primary winding (21) or the secondary winding (22) of the second transformer (20) as resonant circuit inductance (21; 22) and has a second resonant circuit capacitance (32),

a coupling element (33) couples the first resonant circuit (1) to the second resonant circuit (2),

evaluating a phase relation between the signals (Vs1, Vs2) which are picked up from the secondary windings (12, 22) of the transformers.

24. Signal transmitting method according to Claim 13, which exhibits the following method steps for transmitting a two-valued data sequence (D) with first and second data symbols:

transmitting a first transmit symbol (c) for a first data symbol of the data sequence (D),
transmitting a second transmit symbol (a) for a second data symbol of the data sequence (D),
alternately transmitting the first transmit symbol (c) and a third transmit symbol (b) for at least two successive first data symbols of the data sequence (D), and
alternately transmitting the second transmit symbol (a) and the third transmit symbol (b) for at least two successive second data symbols of the data sequence (D).

25. Signal transmitting method according to Claim 23, in which, for transmitting n, with $n \geq 2$, in each case two-valued data sequences (DO, D1, D3) assuming a first or second data value, a transmit symbol sequence with n successive transmit symbols is transmitted, of which each transmit symbol represents the data value of a data sequence (DO, D1, D2).

## Revendications

1. Dispositif de transmission de signal pour la transmission d'au moins deux symboles (a, b, c) d'émission différents, qui a :

un premier transformateur (10) ayant un enroulement (11) primaire et un enroulement (12) secondaire couplés inductivement l'un à l'autre et un deuxième transformateur (20) ayant un enroulement (21) primaire et un enroulement (22) secondaires couplés inductivement l'un à l'autre,
un premier circuit (1) oscillant ayant l'enroulement (11) primaire ou l'enroulement (12) secondaire du premier transformateur (10) comme inductance (11; 12) de circuit oscillant et ayant une première capacité (31) de circuit oscillant et un deuxième circuit (2) oscillant ayant l'enroulement (21) primaire ou l'enroulement (22) secondaire du deuxième transformateur (20) comme inductance (21; 22) de circuit oscillant et ayant une deuxième capacité (32) de circuit oscillant,
un élément (33) de couplage, qui couple le premier circuit (1) oscillant au deuxième circuit (2) oscillant,
un premier circuit (41) d'excitation, qui est couplé au premier circuit (1) oscillant, et au moins un autre circuit (42, 43) d'excitation, qui est couplé au deuxième circuit (2) oscillant,
dans lequel le premier circuit (41) d'excitation et le au moins un autre circuit (42, 43) d'excitation sont constitués respectivement pour, dans un état activé, exciter dans le premier circuit oscillant et dans le deuxième circuit oscillant respectivement, en fonction de l'un des au moins deux symboles (a, b, c) différents, en oscillations, qui sont déphasées les unes par rapport aux autres d'un déphasage différent de zéro, ces déphasages étant différents pour le premier circuit (41) d'excitation et pour le au moins un autre circuit (42, 43) d'excitation.

2. Dispositif de transmission de signal suivant la revendication 1, qui a un deuxième circuit (42) d'excitation couplé aux premier et deuxième circuits (1, 2) oscillants et qui a un troisième circuit (43) d'excitation couplé au deuxième circuit (2) oscillant.

3. Dispositif de transmission de signal suivant la revendication 2, dans lequel le deuxième circuit (42) d'excitation est constitué de manière à exciter dans le premier et le deuxième circuits (1, 2) oscillants des oscillations en opposition de phase.

4. Dispositif de transmission de signal suivant l'une des revendications précédentes, dans lequel l'enroulement (11) primaire du premier transformateur forme l'inductance du premier circuit (1) oscillant, l'enroulement (21) primaire du deuxième transformateur (20) forme l'inductance du deuxième circuit (2) oscillant.

5. Dispositif de transmission de signal suivant la revendication 4, dans lequel le premier circuit (41) d'excitation est relié directement au premier circuit (1) oscillant et l'autre circuit (43) d'excitation est relié directement au deuxième circuit (2) oscillant.

**6.** Dispositif de transmission de signal suivant la revendication 4,
qui a un premier enroulement (17) d'excitation, qui est couplé inductivement au premier enroulement (11) primaire du premier circuit (1) oscillant et auquel le premier circuit (41) d'excitation est relié, et
qui a un deuxième enroulement (27) d'excitation, qui est couplé inductivement à l'enroulement (21) primaire du deuxième circuit (2) oscillant et auquel l'autre circuit (43) d'excitation est relié.

**7.** Dispositif de transmission de signal suivant l'une des revendications 1 à 3, dans lequel
l'enroulement (12) secondaire du premier transformateur forme l'inductance du premier circuit (1) oscillant,
l'enroulement (22) secondaire du deuxième transformateur (20) forme l'inductance du deuxième circuit (2) oscillant.

**8.** Dispositif de transmission de signal suivant la revendication 7, dans lequel le premier circuit (41) d'excitation est relié à l'enroulement (11) primaire du premier transformateur (10) et l'autre circuit (43) d'excitation est relié à l'enroulement (21) primaire du deuxième transformateur (20).

**9.** Dispositif de transmission de signal suivant l'une des revendications précédentes, dans lequel les circuits oscillants sont couplés directement l'un à l'autre, en montant l'élément (33) de couplage entre les inductances de circuit oscillant.

**10.** Dispositif de transmission de signal suivant l'une des revendications 1 à 8, dans lequel les circuits oscillants sont couplés indirectement l'un à l'autre, en montant l'élément (33) de couplage entre les enroulements du premier et du deuxième transformateurs (10, 20), qui ne forment pas les inductances de circuit oscillant.

**11.** Dispositif de transmission de signal suivant l'une des revendications précédentes, dans lequel l'élément (33) de couplage est un élément de couplage capacitif ou inductif.

**12.** Dispositif de transmission de signal suivant l'une des revendications précédentes, dans lequel le premier et le deuxième circuits (1, 2) oscillants sont des circuits oscillants parallèles.

**13.** Dispositif de transmission de signal suivant l'une des revendications précédentes, dans lequel le premier circuit (41) d'excitation est constitué pour, en fonction d'un premier signal (S1) de commande envoyé au circuit (41) d'excitation, injecter dans le premier circuit (1) oscillant un courant d'excitation, qui dépend d'une tension aux bornes du premier circuit (1) oscillant.

**14.** Dispositif de transmission de signal suivant la revendication 13, dans lequel le courant d'excitation prend un premier niveau de signal ou un deuxième niveau de signal en fonction de la tension aux bornes du premier circuit oscillant.

**15.** Dispositif de transmission de signal suivant la revendication 2, dans lequel le troisième circuit (43) d'excitation est constitué pour, en fonction d'un troisième signal (S3) de commande à envoyer au circuit (43) d'excitation, injecter dans le deuxième circuit (2) oscillant un courant d'excitation, qui dépend d'une tension aux bornes du deuxième circuit (2) oscillant.

**16.** Dispositif de transmission de signal suivant la revendication 15, dans lequel le courant d'excitation prend un premier niveau de signal ou un deuxième niveau de signal en fonction de la tension aux bornes du deuxième circuit oscillant.

**17.** Dispositif de transmission de signal suivant la revendication 2, dans lequel le deuxième circuit (42) d'excitation est constitué pour, en fonction d'un deuxième signal (42) de commande à envoyer au circuit (43) d'excitation, injecter un premier courant (I42_1) d'excitation dans le premier circuit (1) oscillant et dans le deuxième circuit (2) oscillant un deuxième courant (I42_2) déphasé par rapport au premier courant (I42_1).

**18.** Dispositif de transmission de signal suivant la revendication 17, dans lequel le premier et le deuxième courants d'excitation sont des courants en opposition de phase.

**19.** Dispositif de transmission de signal suivant l'une des revendications précédentes, qui a un circuit (50) de démodulation, qui est relié aux enroulements (12, 22) secondaires du premier et du deuxième transformateurs (10, 20) et qui a une unité (53) de formation d'une différence, qui est couplée au premier et au deuxième enroulements (12, 22) secondaires et qui produit un signal (S53) de différence,
une unité (51) de formation de somme, qui est couplée au premier et au deuxième enroulements (12, 22) secondaires et qui produit un signal (S51) de somme,

une unité (52) de déphasage, à laquelle le signal (S51) de somme est envoyé et qui met à disposition un signal (S52) de somme déphasé,

au moins un mélangeur (54), auquel le signal (S53) de différence et un signal qui dépend du signal (S52) de somme déphasé sont envoyés et qui met à disposition un signal (S54) de sortie de mélangeur,

une unité (55 à 58) d'exploitation, à laquelle le signal (S54) de sortie de mélangeur est envoyé et qui produit le au moins un signal (S1', S2', S3') de démodulation en fonction d'une comparaison du signal de sortie du mélangeur à au moins une valeur de seuil.

**20.** Dispositif de transmission de signal suivant la revendication 19, dans lequel l'unité (55 à 58) d'exploitation a :

un premier détecteur (56) de valeur de seuil, qui compare le signal (S54) de sortie du mélangeur à une première valeur de seuil et qui met à disposition un premier signal (S1') de démodulation,

un deuxième détecteur (57) de valeur de seuil, qui compare le signal (S54) de sortie du mélangeur à une deuxième valeur de seuil et qui met à disposition un deuxième signal (S3') de démodulation.

**21.** Dispositif de transmission de signal suivant la revendication 20, dans lequel le signal (S53) de différence est envoyé à l'unité (55 à 58) d'exploitation et dans lequel l'unité (55 à 58) d'exploitation est constituée pour produire un troisième signal (S2') de démodulation en fonction du signal (S53) de différence et des premier et deuxième signaux (S1', S2') de démodulation.

**22.** Dispositif de transmission de signal suivant la revendication 19, dans lequel le circuit (50) de démodulation a les autres caractéristiques suivantes :

un premier mélangeur (54A) et un premier détecteur (55A) de valeurs de seuil monté en aval du premier mélangeur, dans lequel un signal, qui dépend du signal (S52) de somme déphasé et du signal (S53) de différence, est envoyé au premier mélangeur et un premier signal (S1') de démodulation est mis à disposition à une sortie du premier détecteur (55A) de valeurs de seuil,

un deuxième mélangeur (54B) et un deuxième détecteur (55B) de valeurs de seuil monté en aval du deuxième mélangeur (54B), dans lequel un signal, qui dépend du signal (S52) de somme déphasé et du signal (S53) de différence, est envoyé au deuxième mélangeur (54B) et un deuxième signal (S3') de démodulation est mis à disposition à une sortie du deuxième détecteur (55B) de valeur de seuil.

**23.** Procédé de transmission de signal pour la transmission d'au moins deux symboles (a, b, c) d'émission différents ayant les stades de procédé :

excitation d'un premier circuit (1) oscillant et d'un deuxième circuit (2) oscillant par un premier circuit (41) d'excitation et par au moins un autre circuit (42, 43) d'excitation, le premier circuit (41) d'excitation et le au moins un autre circuit (42, 43) d'excitation mettant dans un état activé le premier circuit (1) oscillant et le deuxième circuit (2) oscillant respectivement en fonction de l'un des au moins deux symboles (a, b, c) différents, le premier circuit (1) oscillant et le deuxième circuit (2) oscillant en des oscillations, qui sont déphasées les unes par rapport aux autres d'un déphasage différent de zéro, le déphasage étant différent pour chacun des au moins deux symboles d'émission différents, dans lequel :

un premier transformateur (10) a un enroulement (11) primaire et un enroulement (12) secondaire, qui sont couplés l'un à l'autre inductivement, et un deuxième transformateur (20) a un enroulement (21) primaire et un enroulement (22) secondaire, qui sont couplés l'un à l'autre inductivement,

le premier circuit (1) oscillant a l'enroulement (11) primaire ou l'enroulement (12) secondaire du premier transformateur (10) comme inductance (11, 12) de circuit oscillant et une première capacité (31) de circuit oscillant et le deuxième circuit (2) oscillant a l'enroulement (21) primaire ou l'enroulement (22) secondaire du deuxième transformateur (20) comme inductance (21, 22) de circuit oscillant et une deuxième capacité (32) de circuit oscillant,

un élément (33) de couplage couple le premier circuit (1) oscillant au deuxième circuit (2) oscillant,

exploitation d'un rapport de phase entre les signaux (Vs1, Vs2) prélevés des enroulements (12, 22) secondaires des transformateurs.

**24.** Procédé de transmission de signal suivant la revendication 23, qui a, pour la transmission d'une séquence (D) de données binaires ayant des premiers et des deuxièmes symboles de données, les stades de procédé :

transmission d'un premier symbole (c) d'émission pour un premier symbole de données de la séquence (D) de données,

transmission d'un deuxième symbole (a) d'émission pour un deuxième symbole de données de la séquence (D) de données,

transmission alternée du premier symbole (c) d'émission et d'un troisième symbole (b) d'émission pour au moins deux premiers symboles de données successifs de la séquence (D) de données, et

transmission alternée du deuxième symbole (a) d'émission et du troisième symbole (b) d'émission pour au moins deux deuxièmes symboles de données successifs de la séquence (D) de données.

**25.** Procédé de transmission de signal suivant la revendication 23, dans lequel, pour une transmission de n, n≥ 2, séquences (D0, D1, D3) de données respectivement binaires et prenant une première ou une deuxième valeur de données, on transmet une séquence de symboles d'émission ayant n symboles d'émission successifs, dont chaque symbole d'émission représente la valeur de données d'une séquence (D0, D1, D2) de données.

## FIG 1

## FIG 2

# FIG 3A

# FIG 3B

# FIG 3C

# FIG 4

# FIG 5

FIG 6

FIG 7

EP 1 860 838 B1

FIG 8

EP 1 860 838 B1

FIG 9

FIG 10

$$V1 = \frac{Vsum + d \cdot Vdiff}{1+d}$$

# FIG 11

EP 1 860 838 B1

## FIG 12

D:  1    0    1    0    0    1    1    1

S:  c    a    c    a    b    c    b    c

## FIG 13

```
        1/c                              0/a
       /   \                            /   \
     1/b     0/a                      1/c     0/b
    /  \     /  \                    /  \     /  \
  1/c  0/a 0/b  1/c               1/b  0/a 1/c  0/a
```

FIG 14

# FIG 15

D0           1/c                          0/a

D1     0/a        1/b           0/b       1/c

D2   0/b    1/c   0/a     1/c     0/a    1/c   0/a     1/b

# FIG 16

EP 1 860 838 B1

# FIG 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6525566 B2
- DE 1052447
- DE 10100282 A1
- DE 10232642 A1